(19) Europäisches Patentamt
European Patent Office
Office européen des brevets

(11) EP 1 647 062 B1

(12) **EUROPEAN PATENT SPECIFICATION**

(45) Date of publication and mention of the grant of the patent:
**22.08.2007 Bulletin 2007/34**

(21) Application number: **04744403.9**

(22) Date of filing: **24.06.2004**

(51) Int Cl.:
***H01L 51/00*** *(2006.01)*

(86) International application number:
**PCT/IB2004/050999**

(87) International publication number:
**WO 2005/004251 (13.01.2005 Gazette 2005/02)**

(54) **MULTIFLUORINATED CONDUCTOR MATERIAL FOR LEDS FOR IMPROVING THE LIGHT OUTCOUPLING**

MEHRFACHFLUORIERTES LEITERMATERIAL FÜR LEDS ZUR VERBESSERUNG DER LICHTAUSKOPPLUNG

MATERIAU CONDUCTEUR PLUSIEURS FOIS FLUORE POUR DIODES ELECTROLUMINESCENTES DESTINE A AMELIORER LE DECOUPLAGE DE LUMIERE

(84) Designated Contracting States:
**AT BE BG CH CY CZ DE DK EE ES FI FR GB GR HU IE IT LI LU MC NL PL PT RO SE SI SK TR**

(30) Priority: **07.07.2003 EP 03102032**

(43) Date of publication of application:
**19.04.2006 Bulletin 2006/16**

(73) Proprietors:
- **Philips Intellectual Property & Standards GmbH 20099 Hamburg (DE)**
  Designated Contracting States:
  **DE**
- **Koninklijke Philips Electronics N.V. 5621 BA Eindhoven (NL)**
  Designated Contracting States:
  **AT BE BG CH CY CZ DK EE ES FI FR GB GR HU IE IT LI LU MC NL PL PT RO SE SI SK TR**

(72) Inventor: **Boerner, H.F.,**
**Philips I.P. & Standards GmbH**
**52066 Aachen (DE)**

(74) Representative: **Volmer, Georg et al**
**Philips Intellectual Property & Standards GmbH,**
**Postfach 50 04 42**
**52088 Aachen (DE)**

(56) References cited:
**EP-A- 0 848 579**
**EP-A- 0 917 216**
**WO-A-02/45184**

- **HOSHINO S ET AL: "DEVICE PERFORMANCE OF AN N-CHANNEL ORGANIC THIN-FILM TRANSISTOR WITH LIF/AL BILAYER SOURCE AND DRAIN ELECTRODES" JAPANESE JOURNAL OF APPLIED PHYSICS, PUBLICATION OFFICE JAPANESE JOURNAL OF APPLIED PHYSICS. TOKYO, JP, vol. 41, no. 7A, PART 2, 1 July 2002 (2002-07-01), pages L808-L810, XP001151607 ISSN: 0021-4922**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 647 062 B1

## Description

The present invention relates to a conductor material for LEDs for improving the light outcoupling, to an organic light-emitting diode (OLED) or polymer light-emitting diode (polyLED) comprising the conductor material and also to luminous means which comprise such an organic light-emitting diode (OLED) or polymer light-emitting diode (polyLED).

OLEDs are known in the prior art. Typical OLEDs comprise small molecules and are made in a number of layers in the vacuum sublimation method. The simplest form of an organic light-emitting diode OLED consists of three layers. For an application in the field of flat screens, glass coated with ITO (indium tin oxide layer) is used as transparent support and first electrode. Calcium or aluminum, for example, is applied as second electrode to the polymer located thereon. At least two and at most about 7-8 layers are often used in an overall thickness of about 100 nm. The substrate consists of glass which is coated with the transparent conductive material ITO that serves as anode. The cathode consists of thin sputtered metal layers which adjoin the organic layers. The organic materials in which light is generated typically have a refractive index of 1.7. This value applies in the case of a wavelength in the near infrared; at about 1000 nm. Most materials have absorption in the blue or ultraviolet spectral range; the refractive index increases steeply in the direction of these resonance points. The light outcoupling from the layers takes place with a relatively high refractive index of about 1.7-1.8. The ITO has a refractive index in the range of 1.7-1.9.

Both organic light-emitting diodes OLEDs, for example consisting of small molecules, and those consisting of polymers, polyLEDs, have the disadvantage of a too low outcoupling efficiency, which usually outcouples only 20% up to a maximum of 50% of the light generated in the component. The rest of the light is coupled into waveguide modes which pass the light into the substrate or into the light-generating layer itself, where it is ultimately absorbed.

In the prior art there are a large number of organic light-generating materials. By way of example, EP-A2 0 848 579 describes a compound with a triphenylamine structure and a total of six $CF_3$-$CPh_2$-$CF_3$ substituents, this material being suitable for use in an electroluminescent element.

EP-A2 0848579 discloses organic materials partly comprising $CF_3$ substituents for an organic EL device, which has excellent capability of injecting holes from a metal electrode and has durability, and an organic EL device which is imparted with excellent stability by using the above material. EP-A2 0848579 only considers electrical properties in order to enhance the light emission brightness of an EL device.

However, the organic materials used in the prior art as conductor material have a high outcoupling loss. For diodes such as OLEDs or polyLEDs, the outcoupling loss is the greatest source of loss for light emission from the diode. There is therefore a great need for a diode layer, particularly for applications in the display sector, with improved light outcoupling, i.e. a reduction of the outcoupling loss to improve the light generation of a diode.

It is an object of the present invention to provide in particular a conductor material for LEDs with improved light outcoupling properties.

In order to achieve this object, according to the invention a conductor material for LEDs for improving the light outcoupling is provided, wherein

- the conductor material is selected from the group comprising hole conductor material, electron conductor material and/or emitter material,
- the conductor material comprises at least one conductive fluorinated organic substance having at least one fluorinated alkyl substituent, one fluorinated alkenyl substituent and/or one fluorinated alkynyl substituent, wherein at least two fluorine atoms are bonded to at least one carbon atom of the fluorinated substituent, and
- the conductive fluorinated organic substance has a refractive index of ≥ 1.30 and ≤ 1.50.

It has now surprisingly been found that a conductor material layer based on conductive fluorinated organic substances having a refractive index of ≥ 1.30 and ≤ 1.50 outcouples generated light considerably better than conductor material layers consisting of substances having a higher refractive index, with the outcoupling of light increasing as the refractive index of the conductive fluorinated organic substances according to the invention in the light-emitting layer decreases. Consequently, conductive fluorinated organic substances which have a refractive index of ≤ 1.45 and ≥ 1,34, more preferably of ≤ 1.43 and ≥ 1.35, particularly preferably of ≤ 1.41 and ≥ 1.37 and most preferably a refractive index of ≤ 1.41 and ≥ 1.39, are particularly suitable. Further suitable conductive fluorinated organic substances may have a refractive index of 1.349, 1.352, 1.361 or 1.407, with a mean deviation of the refractive index of ± 0.002.

Besides an advantageous refractive index of ≥ 1.30 and ≤ 1.50, these materials also have a low dielectric constant ε.

Within the context of this invention, the conductor material may be a hole conductor material, electron conductor material and/or emitter material.

The conductive fluorinated organic substances according to the invention are thus particularly suitable as conductor material for the production of layers, for example for LEDs such as OLEDs or polyLEDs. Corresponding organic light-emitting diodes (OLEDs) or polymer light-emitting diodes (polyLEDs) according to the invention may comprise one or more layers of at least one conductive fluorinated organic substance with a refractive index of ≤ 1.50 and ≥ 1.30, preferably of ≤ 1.45 and ≥ 1.34, more preferably of ≤ 1.43 and ≥ 1.35, particularly preferably of ≤ 1.41 and ≥ 1.37 and most preferably a refractive index of ≤ 1.40 and ≥ 1.39.

OLEDs and/or polyLEDs according to the invention may be used in particular for luminous means. Such luminous means may comprise at least one, preferably 2 to 10, OLEDs and/or polyLEDs. The number of OLEDs and/or polyLEDs in the luminous means according to the invention may also be considerably higher.

Diodes according to the invention, such as OLEDs and/or polyLEDs may be contained in luminous means such as lamps, lights, beamers, segment-based and pixel-based display elements, background lighting systems of LCD displays of all kinds, emergency lighting and the like.

In order to improve the light outcoupling, it is therefore preferred that at least one light-outcoupling layer of the LED comprises at least one conductive fluorinated organic substance according to the invention. According to the invention, it is advantageous if the layer comprises, based on the overall weight of the layer, at least 20% by weight, preferably at least 30% by weight, more preferably at least 40% by weight, even more preferably at least 50% by weight, still more preferably at least 60% by weight, yet more preferably at least 70% by weight and most preferably at least 80% by weight of at least one of the conductive fluorinated organic substances according to the invention. One or more layers may also consist entirely of at least one, preferably at least 2 to 10, conductive fluorinated organic substances according to the invention.

The diode, in particular LED or OLED, may comprise at least one layer according to the invention, preferably 2 to 10 and more preferably 3 to 7 layers according to the invention. Layers formed according to the invention may comprise identical or different conductive fluorinated organic substances. Moreover, the weight content of the conductive fluorinated organic substances used according to the invention in the respective layers, based on the respective overall weight of the layer, may be identical or different.

It may be advantageous for the light outcoupling if the mean refractive index of all substances of at least one layer formed according to the invention is in the range of ≤ 1.5 and ≥ 1.3, preferably of ≤ 1.45 and ≥ 1.34, more preferably of ≤ 1.43 and ≥ 1.35, particularly preferably of ≤ 1.41 and ≥ 1.37 and most preferably in the range of ≤ 1.41 and ≥ 1.39.

The light outcoupling for a diode with at least one layer formed according to the invention, measured in lumens, with the layer having a mean refractive index D of ≥ 1.3 and ≤ 1.5, may be for example around at least 5%, preferably around at least 10%, more preferably around at least 15%, even more preferably around at least 20%, still more preferably around at least 30% and most preferably around at least 40%, compared to the same arrangement but consisting of a conductor material having a higher mean refractive index D of X=1.8.

Typical values for the layer thicknesses in a diode, in particular an OLED, are 15-150 nm for the ITO and 50-300 nm for the organic layers.

According to the invention, it has been found that conductor materials in which a number of hydrogen atoms are replaced by fluorine atoms and which then have a refractive index D of ≥ 1.30 and ≤ 1.50 are suitable according to the invention. Substances with perfluorinated linear or branched alkyl, alkenyl and/or alkynyl radicals or substituents with at least 4 carbon atoms, preferably 5 to 20 carbon atoms, in the chain have proven to be particularly advantageous for use as conductor materials for forming a diode layer.

Hereinbelow, substances which can be used according to the invention will be given, it being possible for these substances to be used for example as electron or hole conductors, in particular in OLEDs.

Conductive fluorinated organic substances that are suitable according to the invention may be selected from the group comprising aryl compounds, perfluorinated adamantane, triphenylamine compounds, carbazole compounds, oxadiazole compounds, triazole compounds, triazine compounds, fluorene compounds, hexaphenylbenzene compounds, phenanthroline compounds, pyridine compounds, polyfluorene with perfluorinated side chains, conjugated polymers, poly-para-phenylene vinylene (PPV), polyvinylcarbazole, metal complexes, in particular metal complexes comprising Al, Ga and/or Zn as metal ion, quinoline compounds, acetylacetonate compounds, bipyridine compounds, phenanthroline compounds and/or metal complexes comprising carboxylic acids as ligand.

Conductive fluorinated organic substances that are suitable according to the invention preferably have at least one fluorinated substituent in the form of a linear or branched alkyl, alkenyl and/or alkynyl radical or substituent.

Fluorinated substituents for which $C_mF_{m+x}$ are preferred, in which

m = 1 to 30, preferably m = 2 to 20, more preferably m = 4 to 17, even more preferably 6 to 15; and
X = 0 to m+1, with m being an integer. X is preferably at least 1 and at most 2·m+1.

According to one embodiment according to the invention, m = 4 to 18 and X = m to 2 · m + 1.

According to a further embodiment according to the invention, m = 8 to 16 and X = m to 2 · m+ 1.

According to a further embodiment according to the invention, m = 10 to 14 and X = m to 2 · m + 1.

The maximum number of X is limited by the maximum possible number of fluorine atoms for the respective substituent. Thus, X is greater for an unsaturated linear alkyl radical or substituent than compared to a linear unsaturated

radical or substituent with the same chain length.

The conductive fluorinated organic substance may be a monomer, oligomer or polymer, wherein the conductive fluorinated substance preferably comprises conjugated double and/or triple bonds and may preferably have a molecular weight of ≥ 100 and ≤ 300,000, more preferably ≥ 1000 and ≤ 200,000, even more preferably ≥ 10,000 and ≤ 200,000 and yet more preferably ≥ 50,000 and ≤ 100,000. The molecular weight for polymers that can be used according to the invention may also be considerably greater than 300,000.

Within the context of this invention, the terms "alkyl, alkenyl, alkynyl, alkoxy, aryl, alkylene, arylene, amines, halogen, carboxylate derivatives, cycloalkyl, carbonyl derivatives, heterocycloalkyl, heteroaryl, heteroarylene, sulfonate, sulfate, phosphonate, phosphate, phosphine, phosphine oxide", unless stated otherwise, represent:

alkyl = linear or branched $C_1$-$C_{20}$-alkyl, preferably ethyl, propyl, isopropyl, tert-butyl, butyl, pentane.
alkenyl = $C_2$-$C_{20}$-alkenyl.
alkynyl = $C_2$-$C_{20}$-alkynyl.
cycloalkyl = $C_3$-$C_{10}$-cycloalkyl.
alkoxy = $C_1$-$C_6$-alkoxy.
alkylene = methylene; 1,1-ethylene; 1,2-ethylene; 1,1-propylidene; 1,2-propylene; 1,3-propylene; 2,2-propylidene; butan-2-ol-1,4-diyl; propan-2-ol-1,3-diyl; 1,4-butylene; cyclohexane-1,1-diyl; cyclohexane-1,2-diyl; cyclohexane-1,3-diyl; cyclohexane-1,4-diyl; cyclopentane-1,1-diyl; cyclopentane-1,2-diyl; and/or cyclopentane-1,3-diyl.
aryl = homo- or heteroaromatics having a molecular weight of ≤ 300.
arylene = 1,2-phenylene; 1,3-phenylene; 1,4-phenylene; 1,2-naphthalenylene; 1,3-naphthalenylene; 1,4-naphthalenylene; 2,3-naphthalenylene; 1-hydroxy-2,3-phenylene; 1-hydroxy-2,4-phenylene; 1-hydroxy-2,5-phenylene; and/or 1-hydroxy-2,6-phenylene.
heteroaryl = pyridinyl; pyrimidinyl; pyrazinyl; triazolyl; pyridazinyl; 1,3,5-triazinyl; quinolinyl; isoquinolinyl; quinoxalinyl; imidazolyl; pyrazolyl; benzimidazolyl; thiazolyl; oxazolidinyl; pyrrolyl; carbazolyl; indolyl; and/or isoindolyl.
heteroarylene = pyridinediyl; quinolinediyl; pyrazodiyl; pyrazolediyl; triazolediyl; pyrazinediyl; and/or imidazolediyl; in particular pyridine-2,3-diyl; pyridine-2,4-diyl; pyridine-2,5-diyl; pyridine-2,6-diyl; pyridine-3,4-diyl; pyridine-3,5-diyl; quinoline-2,3-diyl; quinoline-2,4-diyl; quinoline-2,8-diyl; isoquinoline-1,3-diyl; isoquinoline-1,4-diyl; pyrazole-1,3-diyl; pyrazole-3,5-diyl; triazole-3,5-diyl; triazole-1,3-diyl; pyrazine-2,5-diyl; and/or imidazole-2,4-diyl.
C1-C6-heterocycloalkyl = piperidinyl; piperidine; 1,4-piperazine, tetrahydrothiophene; tetrahydrofuran; 1,4,7-triazacyclononane; 1,4,8,11-tetraazacyclotetradecane; 1,4,7,10,13-pentaazacyclopentadecane; 1,4-diaza-7-thiacyclononane; 1,4-diaza-7-oxacyclononane; 1,4,7,10-tetraazacyclododecane; 1,4-dioxane; 1,4,7-trithiacyclononane; pyrrolidine; and/or tetrahydropyran.
heterocycloalkylene = piperidin-1,2-ylene; piperidin-2,6-ylene; piperidin-4,4-ylidene; 1,4-piperazin-1,4-ylene; 1,4-piperazin-2,3-ylene; 1,4-piperazin-2,5-ylene; 1,4-piperazin-2,6-ylene; 1,4-piperazin-1,2-ylene; 1,4-piperazin-1,3-ylene; 1,4-piperazin-1,4-ylene; tetrahydrothiophen-2,5-ylene; tetrahydrothiophen-3,4-ylene; tetrahydrothiophen-2,3-ylene; tetrahydrofuran-2,5-ylene; tetrahydrofuran-3,4-ylene; tetrahydrofuran-2,3-ylene; pyrrolidin-2,5-ylene; pyrrolidin-3,4-ylene; pyrrolidin-2,3-ylene; pyrrolidin-1,2-ylene; pyrrolidin-1,3-ylene; pyrrolidin-2,2-ylidene; 1,4,7-triazacyclonon-1,4-ylene; 1,4,7-triazacyclonon-2,3-ylene; 1,4,7-triazacyclonon-2,9-ylene; 1,4,7-triazacyclonon-3,8-ylene; 1,4,7-triazacyclonon-2,2-ylidene; 1,4,8,11-tetraazacyclotetradec-1,4-ylene; 1,4,8,11-tetraazacyclotetradec-1,8-ylene; 1,4,8,11-tetraazacyclotetradec-2,3-ylene; 1,4,8,11-tetraazacyclotetradec-2,5-ylene; 1,4,8,11-tetraazacyclotetradec-1,2-ylene; 1,4,8,11-tetraazacyclotetradec-2,2-ylidene; 1,4,7,10-tetraazacyclododec-1,4-ylene; 1,4,7,10-tetraazacyclododec-1,7-ylene; 1,4,7,10-tetraazacyclododec-1,2-ylene; 1,4,7,10-tetraazacyclododec-2,3-ylene; 1,4,7,10-tetraazacyclododec-2,2-ylidene; 1,4,7,10,13-pentaazacyclopentadec-1,4-ylene; 1,4,7,10,13-pentaazacyclopentadec-1,7-ylene; 1,4,7,10,13-pentaazacyclopentadec-2,3-ylene; 1,4,7,10,13-pentaazacyclopentadec-1,2-ylene; 1,4,7,10,13-pentaazacyclopentadec-2,2-ylidene; 1,4-diaza-7-thiacyclonon-1,4-ylene; 1,4-diaza-7-thiacyclonon-1,2-ylene; 1,4-diaza-7-thiacyclonon-2,3-ylene; 1,4-diaza-7-thiacyclonon-6,8-ylene; 1,4-diaza-7-thiacyclonon-2,2-ylidene; 1,4-diaza-7-oxacyclonon-1,4-ylene; 1,4-diaza-7-oxacyclonon-1,2-ylene; 1,4-diaza-7-oxacyclonon-2,3-ylene; 1,4-diaza-7-oxacyclonon-6,8-ylene; 1,4-diaza-7-oxacyclonon-2,2-ylidene; 1,4-dioxan-2,3-ylene; 1,4-dioxan-2,6-ylene; 1,4-dioxan-2,2-ylidene; tetrahydropyran-2,3-ylene; tetrahydropyran-2,6-ylene; tetrahydropyran-2,5-ylene; tetrahydropyran-2,2-ylidene; 1,4,7-trithiacyclonon-2,3-ylene; 1,4,7-trithiacyclonon-2,9-ylene; and/or 1,4,7-trithiacyclonon-2,2-ylidene.
heterocycloalkyl = pyrrolinyl; pyrrolidinyl; morpholinyl; piperidinyl; piperazinyl; hexamethyleneimine; 1,4-piperazinyl; tetrahydrothiophenyl; tetrahydrofuranyl; 1,4,7-triazacyclononanyl; 1,4,8,11-tetraazacyclotetradecanyl; 1,4,7,10,13-pentaazacyclopentadecanyl; 1,4-diaza-7-thiacyclononanyl; 1,4-diaza-7-oxacyclononanyl; 1,4,7,10-tetraazacyclododecanyl; 1,4-dioxanyl; 1,4,7-trithiacyclononanyl; tetrahydropyranyl; and/or oxazolidinyl.
amines = $-N(R)_2$ in which each R independently of one another is selected from the group comprising: H; $C_1$-$C_6$-alkyl; $C_1$-$C_6$-alkyl-$C_6H_5$; and/or phenyl, wherein both Rs may form an $-NC_3$ to $-NC_5$ heterocyclic ring closure.
halogen = F; Cl; Br and/or I, particularly preferably F.

sulfonate = $-S(O)_2OR$, in which R = H; $C_1$-$C_6$-alkyl; phenyl; $C_1$-$C_6$-alkyl-$C_6H_5$; Li; Na; K; Cs; Mg; and/or Ca.

sulfate = $-OS(O)_2OR$, in which R = H; $C_1$-$C_6$-alkyl; phenyl; $C_1$-$C_6$-alkyl-$C_6H_5$; Li; Na; K; Cs; Mg; and/or Ca.

sulfone: $-S(O)_2R$, in which R = H; $C_1$-$C_6$-alkyl; phenyl; $C_1$-$C_6$-alkyl-$C_6H_5$ and/or amines (to form sulfonamide) selected from the group comprising: -NR'$_2$, in which each R' independently of one another is selected from the group comprising: H; $C_1$-$C_6$-alkyl; $C_1$-$C_6$-alkyl-$C_6H_5$; and/or phenyl, wherein if both R's = $C_1$-$C_6$-alkyl, the R's together may form an -$NC_3$ to -$NC_5$ heterocyclic ring closure.

carboxylate derivatives = -C(O)OR, in which R is selected from the group comprising: H; $C_1$-$C_{20}$-alkyl; phenyl; $C_1$-$C_6$-alkyl-$C_6H_5$; Li; Na; K; Cs; Mg; and/or Ca.

carbonyl derivatives = -C(O)R, in which R is selected from the group comprising: H; $C_1$-$C_6$-alkyl; phenyl; $C_1$-$C_6$-alkyl-$C_6H_5$ and/or amine (to form amide) selected from the group comprising: -NR'$_2$, in which each R' independently of one another is selected from the group comprising: H; $C_1$-$C_6$-alkyl; $C_1$-$C_6$-alkyl-$C_6H_5$; and/or phenyl, wherein if both R's = $C_1$-$C_6$-alkyl, the R's together may form an -$NC_3$ to -$NC_5$ heterocyclic ring closure.

phosphonate = $-P(O)(OR)_2$, in which each R independently of one another is selected from the group comprising: H; $C_1$-$C_6$-alkyl; phenyl; $C_1$-$C_6$-alkyl-$C_6H_5$; Li; Na; K; Cs; Mg; and/or Ca.

phosphate = $-OP(O)(OR)_2$, in which each R independently of one another is selected from the group comprising: H; $C_1$-$C_6$-alkyl; phenyl; $C_1$-$C_6$-alkyl-$C_6H_5$; Li; Na; K; Cs; Mg; and/or Ca.

phosphine = $-P(R)_2$, in which each R independently of one another is selected from the group comprising: H; $C_1$-$C_6$-alkyl; phenyl; $C_1$-$C_6$-alkyl-$C_6H_5$.

phosphine oxide = $-P(O)R_2$, in which each R independently of one another is selected from the group comprising: H; $C_1$-$C_6$-alkyl; phenyl; $C_1$-$C_6$-alkyl-$C_6H_5$ and/or amine (to form phosphonamidate) selected from the group comprising: -NR'$_2$, in which each R' independently of one another is selected from the group comprising: H; $C_1$-$C_6$-alkyl ; $C_1$-$C_6$-alkyl-$C_6H_5$; and/or phenyl, wherein if both R's = $C_1$-$C_6$-alkyl, the R's together may form an - $NC_3$ to -$NC_5$ heterocyclic ring closure.

$R_1$, $R_2$, $R_3$, $R_4$, $R_5$, $R_6$, $R_7$, $R_8$ and/or $R_9$ are identical or different and are selected from the group comprising hydrogen, hydroxyl, alkyl, alkenyl, alkynyl, alkoxy, aryl, alkylene, arylene, amines, halogen, carboxylate derivatives, cycloalkyl, carbonyl derivatives, heterocycloalkyl, heteroaryl, heteroarylene, sulfonate, sulfate, phosphonate, phosphate, phosphine and/or phosphine oxide, at least one radical R selected from the group $R_1$, $R_2$, $R_3$, $R_4$, $R_5$, $R_6$, $R_7$, $R_8$ and/or $R_9$ representing a fluorinated alkyl substituent, a fluorinated alkenyl substituent and/or a fluorinated alkynyl substituent in which at least two fluorine atoms are bonded to at least one carbon atom.

A conductive fluorinated organic substance that can be used according to the invention may preferably be selected from the group comprising at least one compound having one of the following structural formulae I to XX:

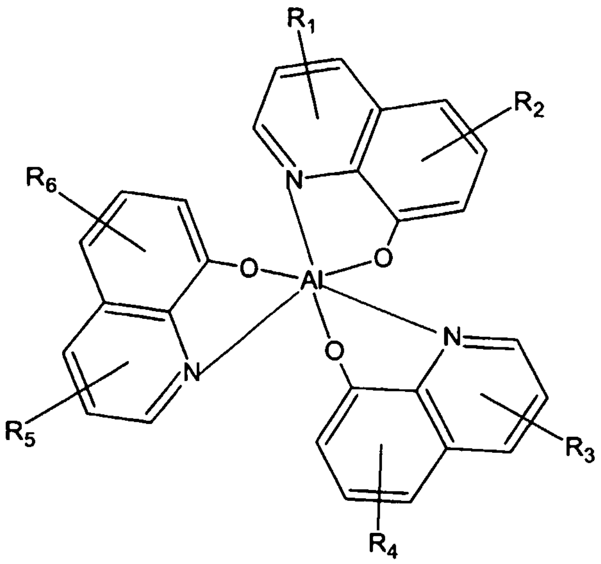

Formula I

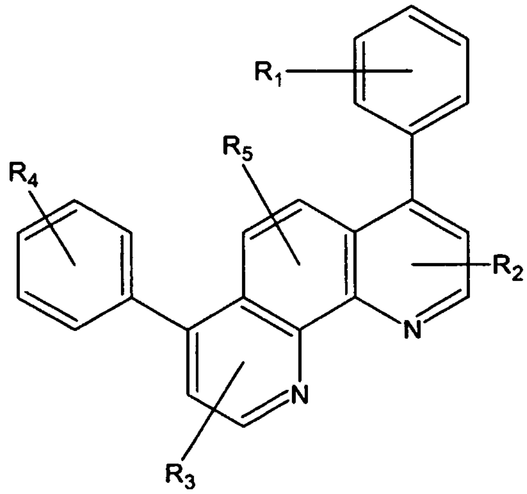

Formula II

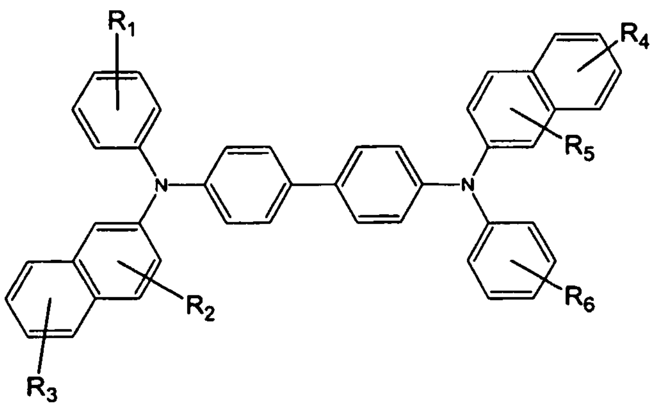

Formula III

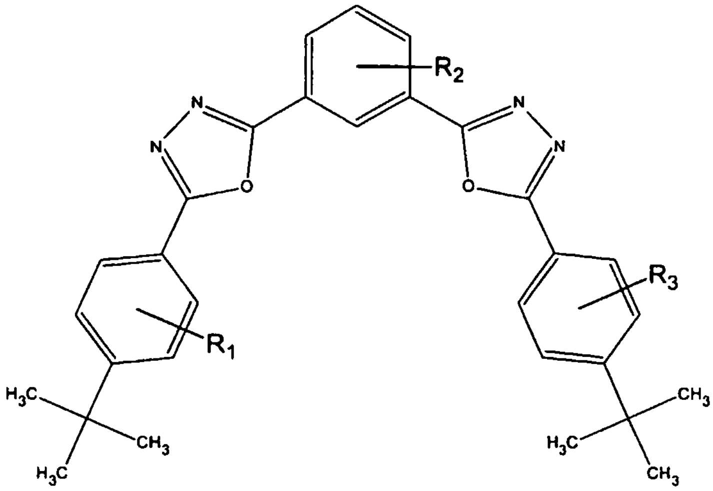

Formula IV

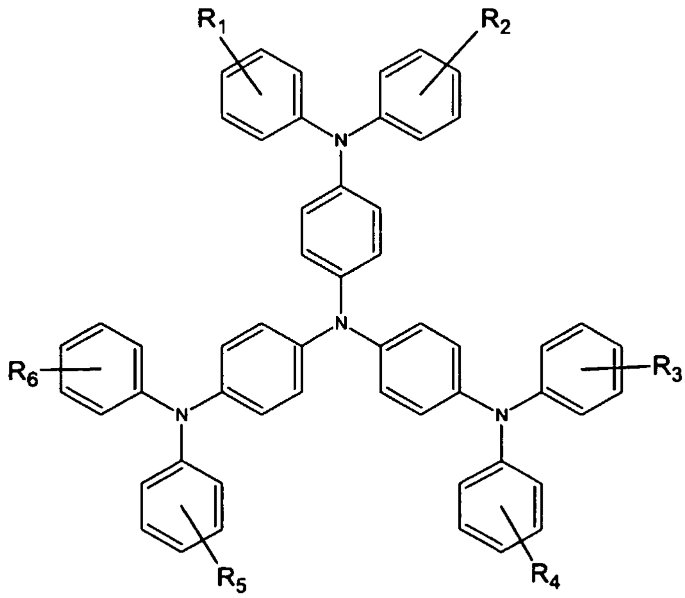

Formula V

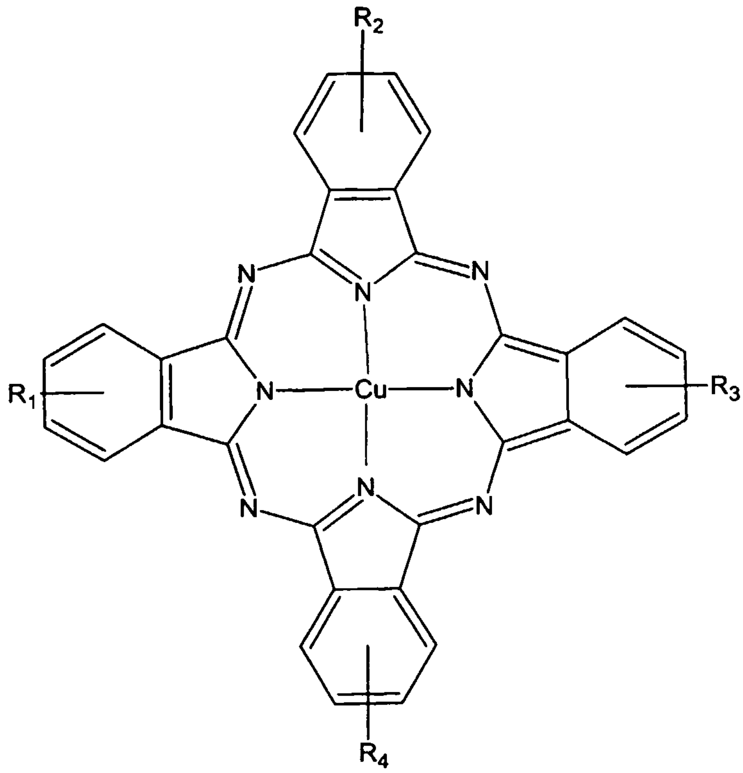

Formula VI

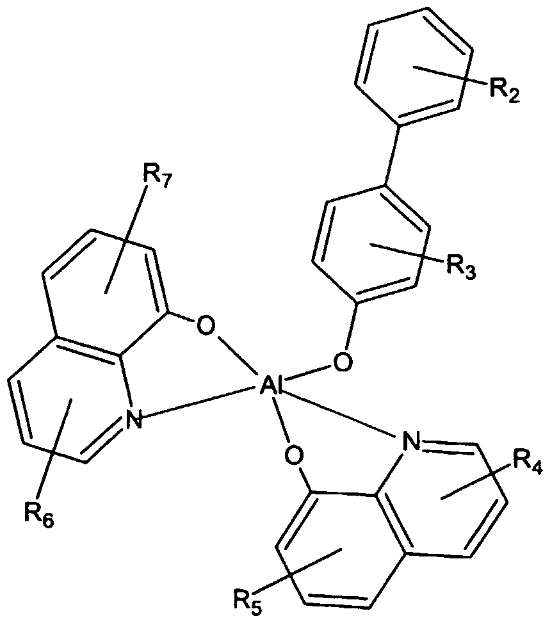

Formula VII

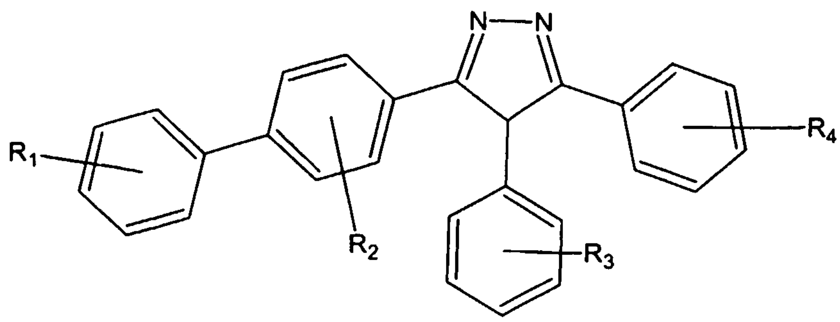

Formula VIII

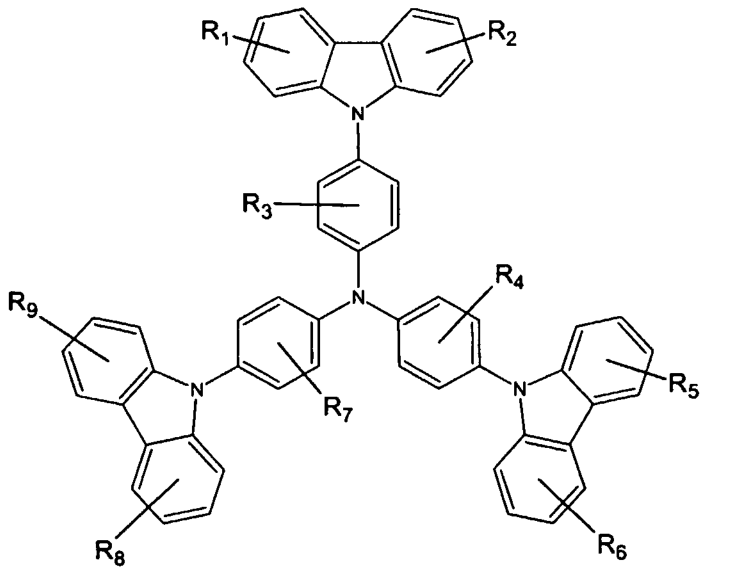

Formula IX

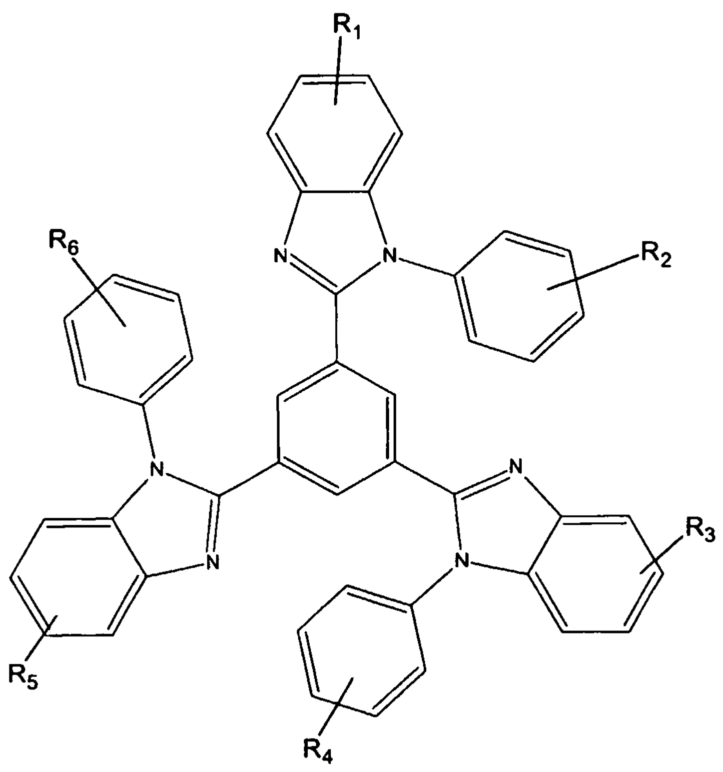

Formula X

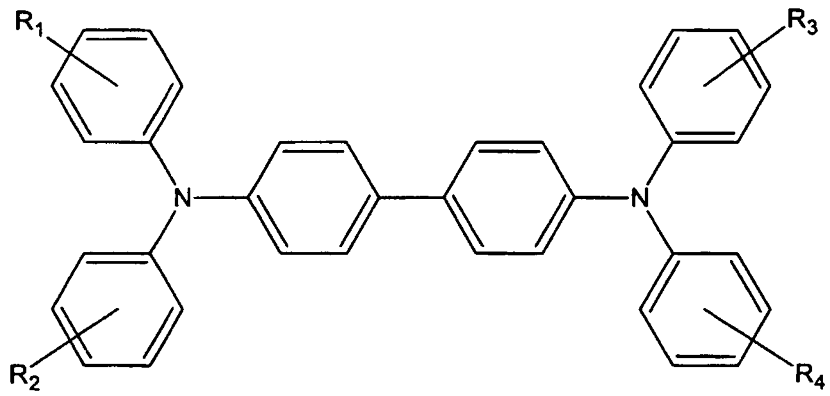

Formula XI

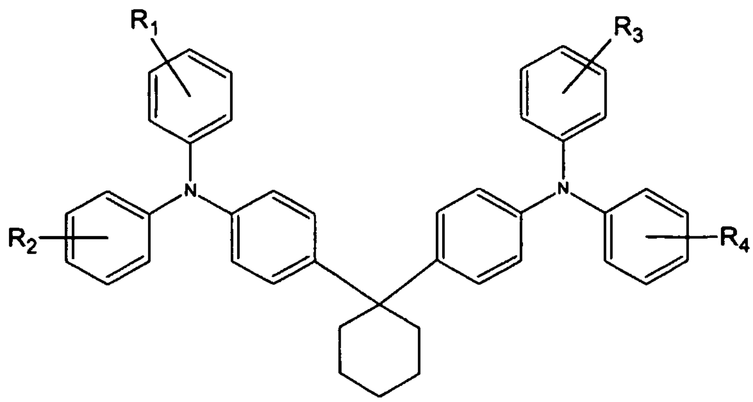

Formula XII

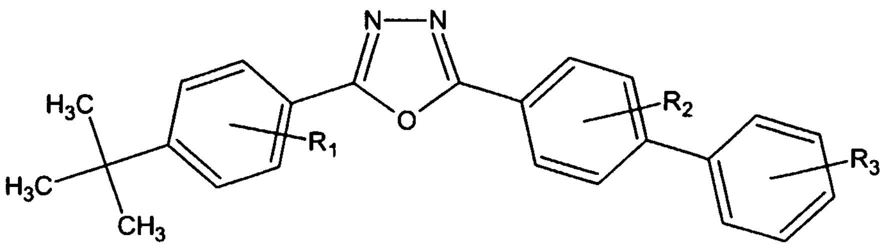

Formula XIII

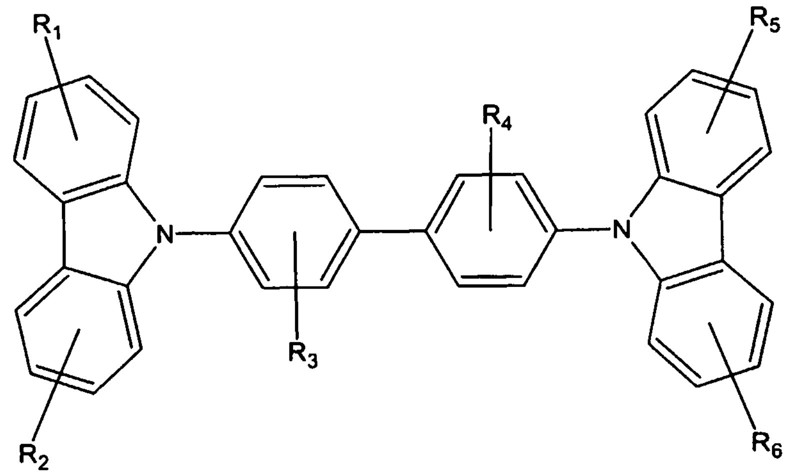

Formula XIV

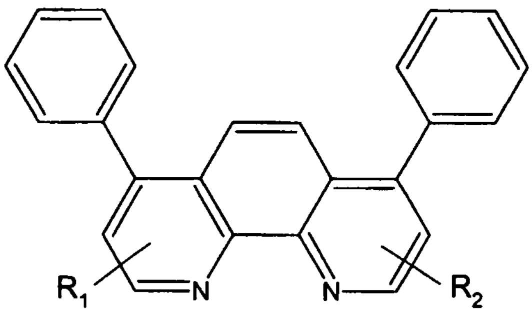

Formula XV

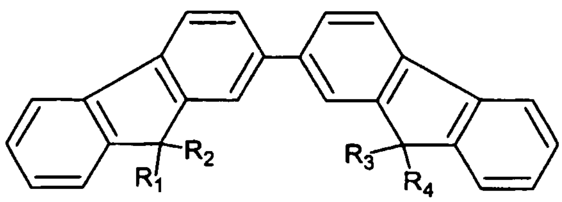

Formula XVI

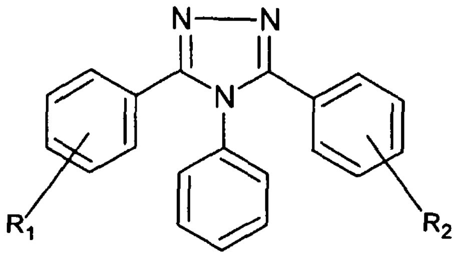

Formula XVII

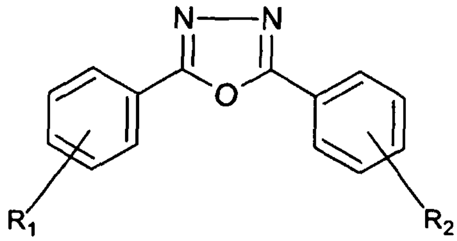

Formula XVIII

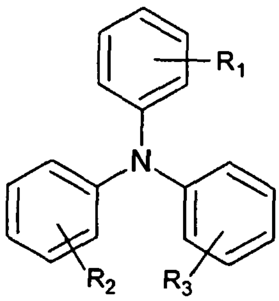

Formula XIX

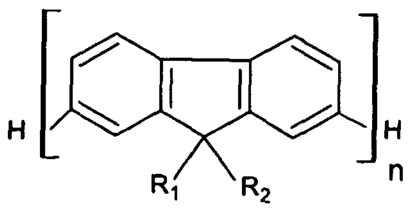

Formula XX

in which $R_1$, $R_2$, $R_3$, $R_4$, $R_5$, $R_6$, $R_7$, $R_8$ and/or $R_9$ are at least partially identical or different and are selected from the group comprising hydrogen, hydroxyl, alkyl, alkenyl, alkynyl, alkoxy, aryl, alkylene, arylene, amines, halogen, carboxylate derivatives, cycloalkyl, carbonyl derivatives, heterocycloalkyl, heteroaryl, heteroarylene, sulfonate, sulfate, phosphonate,

phosphate, phosphine and/or phosphine oxide,
wherein at least one radical R selected from the group $R_1$, $R_2$, $R_3$, $R_4$, $R_5$, $R_6$, $R_7$, $R_8$ and/or $R_9$ represents a fluorinated alkyl substituent, a fluorinated alkenyl substituent and/or a fluorinated alkynyl substituent in which at least two fluorine atoms are bonded to at least one carbon atom;
in which n = 1 to 10,000,000, preferably 10 to 1,000,000, more preferably 100 to 500,000, even more preferably 500 to 250,000, particularly preferably 1000 to 100,000 and most preferably 5000 to 50,000.

Preferably, at least one of the compounds according to formulae I to XX has at least one radical R selected from the group $R_1$, $R_2$, $R_3$, $R_4$, $R_5$, $R_6$, $R_7$, $R_8$ and/or $R_9$ which represents a fluorinated alkyl substituent, a fluorinated alkenyl substituent and/or a fluorinated alkynyl substituent which has at least 3 to 20 carbon atoms, preferably 4 to 15 carbon atoms, more preferably 5 to 12 carbon atoms and even more preferably 6 to 10 carbon atoms, to which at least seven fluorine atoms are bonded.

According to a further embodiment of the present invention, at least one of the compounds according to formulae I to XX has at least one radical R selected from the group $R_1$, $R_2$, $R_3$, $R_4$, $R_5$, $R_6$, $R_7$, $R_8$ and/or $R_9$ which represents a fluorinated alkyl substituent, a fluorinated alkenyl substituent and/or a fluorinated alkynyl substituent which

- has at least 4 carbon atoms, to which at least 7 to 9 fluorine atoms are bonded,
- preferably has at least 6 carbon atoms, to which at least 7 to 13 fluorine atoms are bonded,
- more preferably has at least 8 carbon atoms, to which at least 7 to 17 fluorine atoms are bonded,
- even more preferably has at least 10 carbon atoms, to which at least 7 to 21 fluorine atoms are bonded, and/or
- most preferably at least one alkyl substituent, alkenyl substituent and/or alkynyl substituent is perfluorinated.
  According to the invention, most suitable conductive fluorinated organic substances may preferably be selected from the group comprising at least one compound having one of the following structural formulae XXI to XXVI:

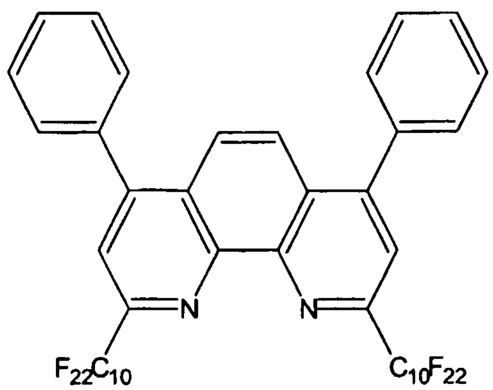

Formula XXI

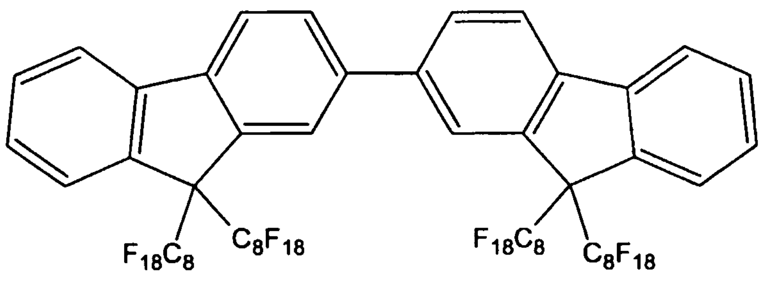

Formula XXII

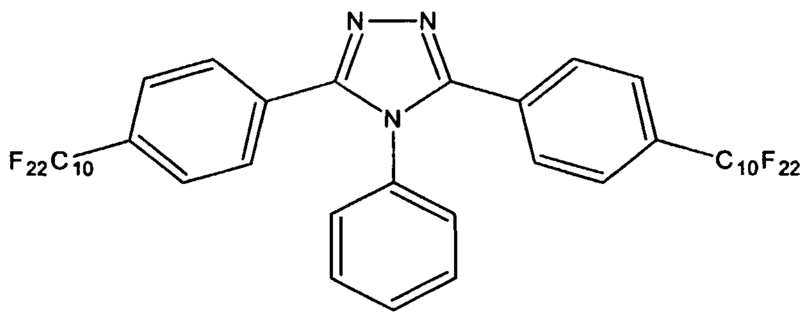

Formula XXIII

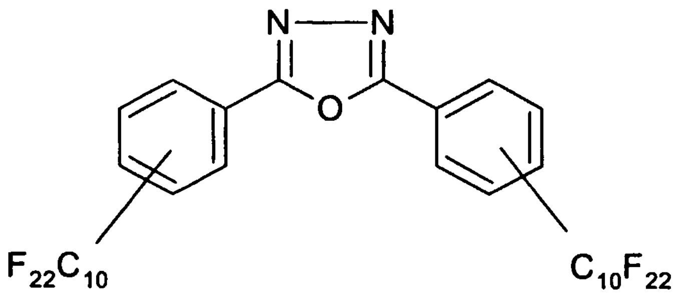

Formula XXIV

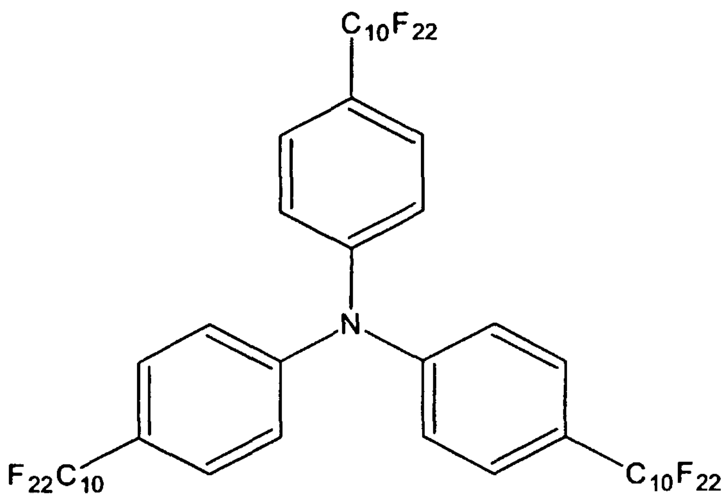

Formula XXV

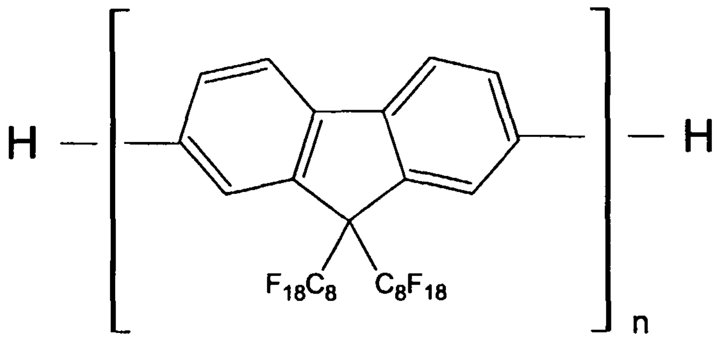

Formula XXVI

in which n = 1 to 10,000,000, preferably 10 to 1,000,000, more preferably 100 to 500,000, even more preferably 500 to 250,000, particularly preferably 1000 to 100,000 and most preferably 5000 to 50,000.

For conductive fluorinated organic substances that can be used according to the invention and have a triphenylamine structure, it is advantageous if these have a fluorinated alkyl substituent, a fluorinated alkenyl substituent and/or a fluorinated alkynyl substituent which

- has at least 4 carbon atoms, to which at least 7 to 9 fluorine atoms are bonded,
- preferably has at least 6 carbon atoms, to which at least 7 to 13 fluorine atoms are bonded,
- more preferably has at least 8 carbon atoms, to which at least 7 to 17 fluorine atoms are bonded, and/or
- most preferably has at least 10 carbon atoms, to which at least 7 to 21 fluorine atoms are bonded,

with the maximum number of fluorine atoms being limited by the respective alkyl substituent, alkenyl substituent and/or alkynyl substituent.

The refractive indices relate to a temperature of 23°C and a wavelength of $\lambda$ = 550 nm and are given to an accuracy of $\pm$ 0.01 unless stated otherwise. A variable angle spectroscopic ellipsometer M2000V from J.A. Woollam was used to measure the refractive index.

In many OLEDs, the following layer structure is used: a first electrode, the anode, is located on a substrate. Adjoining the anode there is a hole-conductive layer, an emitting layer, an electron-conductive layer and a cathode. The holes are transported from the hole-conductive layer, which also facilitates the injection of holes from the anode, into the emitting layer. The emitting layer contains for example a matrix of a hole conductor or electron conductor material in which the light-emitting molecules are embedded. In the emitting layer, the holes meet electrons which are transported from the cathode via the electron-conductive layer into the emitting layer. By recombination of the electrons and holes, excitons are produced which upon return to the basic state release energy. The light-emitting molecules in the emitting layer are excited directly or by energy transfer.

Since in most cases the holes are the majority charge carriers, it is advantageous to add a so-called hole blocking layer between the emitting layer and the electron-conductive layer, which hole blocking layer prevents the transport of holes to the cathode. One disadvantage is that the holes pile up at the interface between emitting layer and hole blocking layer and build up a positive space charge at that point. The OLED thereby acts as a lossy capacitor.

It has been found that as the capacitance increases, the quantum efficiency of an OLED decreases. Causes of this are interactions between the excitons and charge carriers or charges (polarons), which may lead to undesirable quenching of the excitons. These interactions may arise in an amplified manner in the positive space charge zone which is located in the emitting layer.

At a given geometric size (area A, electrode spacing d) of a capacitor, the capacitance C is calculated according to the formula

$$C = (\varepsilon \cdot \varepsilon_0 \cdot A)/d$$

wherein $\varepsilon_0$ is the dielectric constant of empty space (8.854 $10^{-12}$ As/Vm) and $\varepsilon$ is the dielectric constant of the material of the dielectric.

A reduction in the capacitance C may be achieved by reducing the dielectric constant ε of the material of the dielectric, in this case the materials in the layers between anode and cathode and specifically in particular the materials in the emitting layer and the hole blocking layer. In this case, it is advantageous that the dielectric constant ε of the materials is < 5, preferably < 4 and particularly preferably < 3. A dielectric constant ε < 2.8 is very particularly preferred and a dielectric constant ε < 2.5 is even more particularly preferred. These materials have no permanent dipole moment and can be polarized only with difficulty.

By virtue of the reduced capacitance C, the stored charge in the OLED is reduced even at a constant voltage. A reduced space charge reduces the reactions between excitons and charge carriers or charges and thus prevents the undesirable quenching of the excitons.

The above-described materials according to the invention have such a low dielectric constant ε, and by using them as matrix in the emitting layer and/or in the hole blocking layer it is possible for the capacitance C to be lowered and for the quantum efficiency of an OLED to be increased. For instance, the calculated dielectric constant ε of 2,2', 7,7'-tetraphenyl-9,9'-spirobifluorene (spiro-quarterphenyl) is 3.57 and the calculated dielectric constant ε of hexaphenylbenzene is 3.03.

## Claims

1. A conductor material for LEDs for improving the light outcoupling, wherein

   - the conductor material is selected from the group comprising hole conductor material, electron conductor material and/or emitter material,
   - the conductor material comprises at least one conductive fluorinated organic substance having at least one fluorinated alkyl substituent, one fluorinated alkenyl substituent and/or one fluorinated alkynyl substituent, wherein at least two fluorine atoms are bonded to at least one carbon atom of the fluorinated substituent, **characterised in that**
   - the conductive fluorinated organic substance has a refractive index of ≥ 1.30 and ≤ 1.50.

2. A conductor material as claimed in claim 1, wherein the fluorinated substituent is a linear or branched alkyl, alkenyl and/or alkynyl substituent.

3. A conductor material as claimed in claim 1 or 2, wherein $C_mF_{m+X}$ applies in respect of at least one fluorinated substituent, in which

   m = 1 to 20, preferably m = 2 to 16, more preferably m = 4 to 12; and
   X = 1 to m+1, with m being an integer.

4. A conductor material as claimed in any of claims 1 to 3, wherein the conductive fluorinated organic substance is a monomer, oligomer or polymer, the conductive fluorinated substance preferably comprising conjugated double and/or triple bonds and preferably having a molecular weight of ≥ 100 and ≤ 300,000.

5. A conductor material as claimed in any of claims 1 to 4, wherein the conductive fluorinated organic substance is selected from the group comprising aryl compounds, perfluorinated adamantane, triphenylamine compounds, carbazole compounds, oxadiazole compounds, triazole compounds, triazine compounds, fluorene compounds, hexaphenylbenzene compounds, phenanthroline compounds, pyridine compounds, polyfluorene with perfluorinated side chains, conjugated polymers, poly-para-phenylene vinylene (PPV), polyvinylcarbazole, metal complexes, in particular metal complexes comprising Al, Ga and/or Zn as metal ion, quinoline compounds, acetylacetonate compounds, bipyridine compounds, phenathroline compounds and/or metal complexes comprising carboxylic acids as ligand.

6. A conductor material as claimed in any of claims 1 to 5, wherein the conductive fluorinated organic substance has a refractive index of ≤ 1.45, preferably a refractive index of ≤ 1.40, more preferably a refractive index of ≤ 1.39 and even more preferably a refractive index of ≤ 1.37.

7. A conductor material as claimed in any of claims 1 to 6, wherein the conductive fluorinated organic substance is selected from the group comprising at least one compound having one of the following structural formulae I to XX:

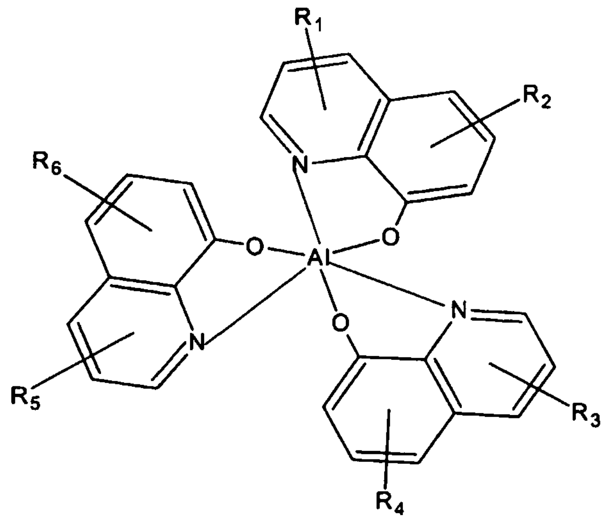

Formula I

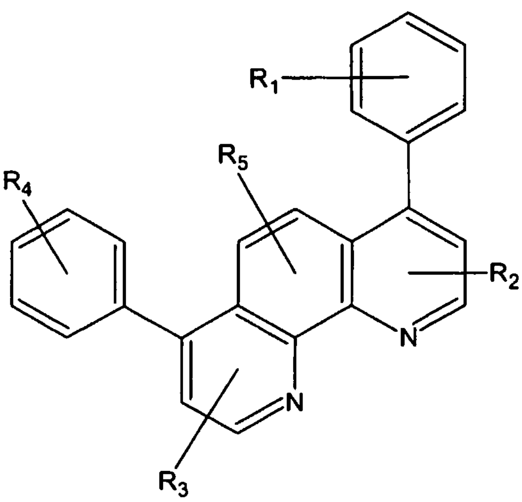

Formula II

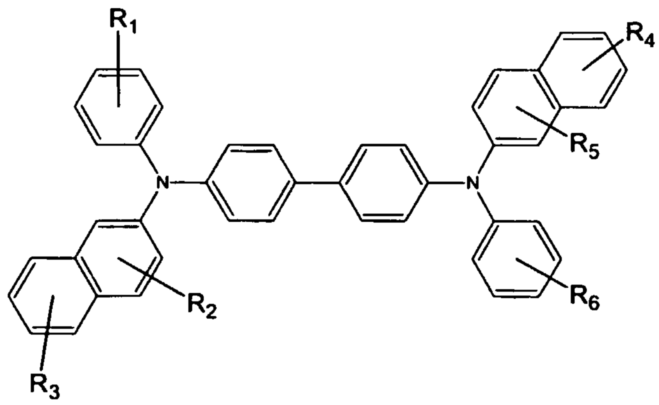

Formula III

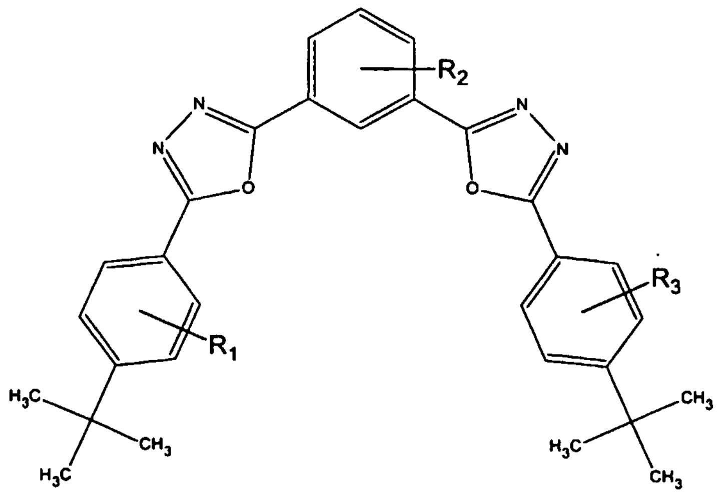

Formula IV

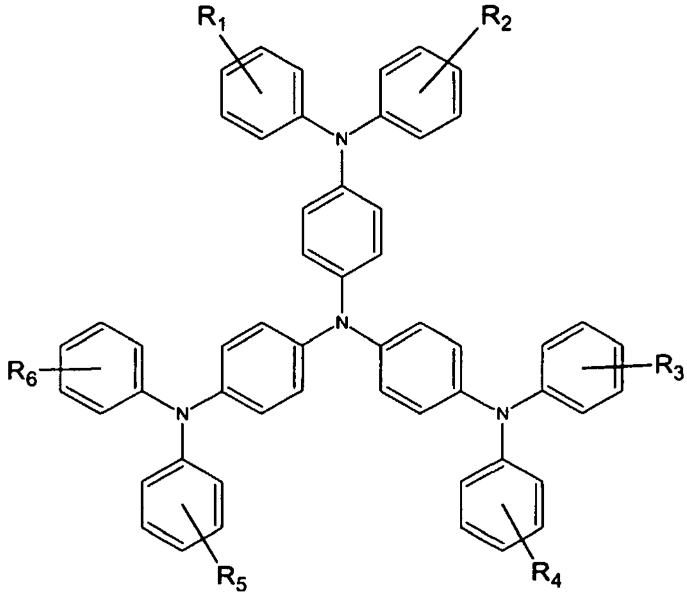

Formula V

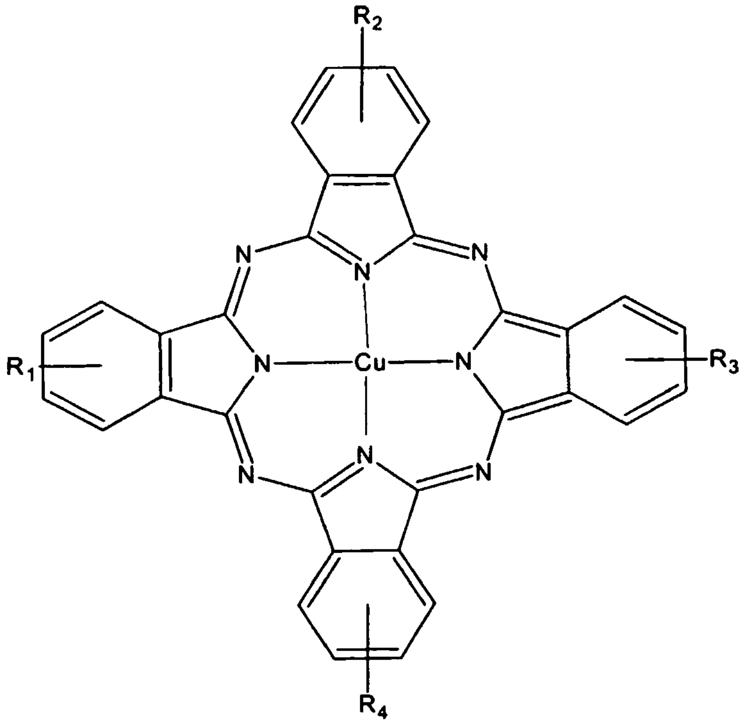

Formula VI

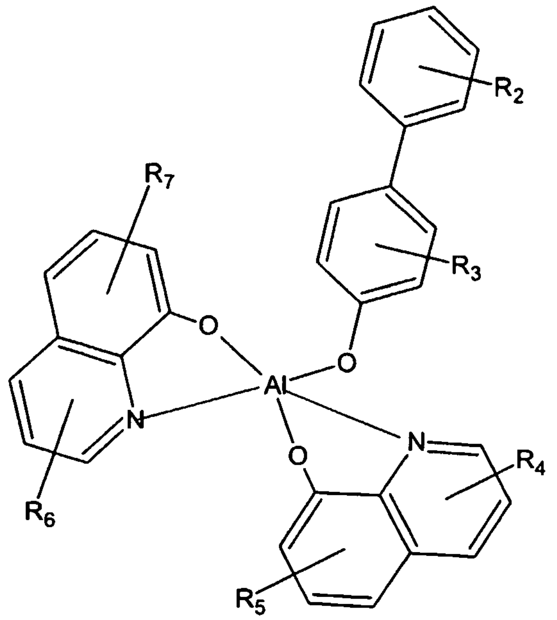

Formula VII

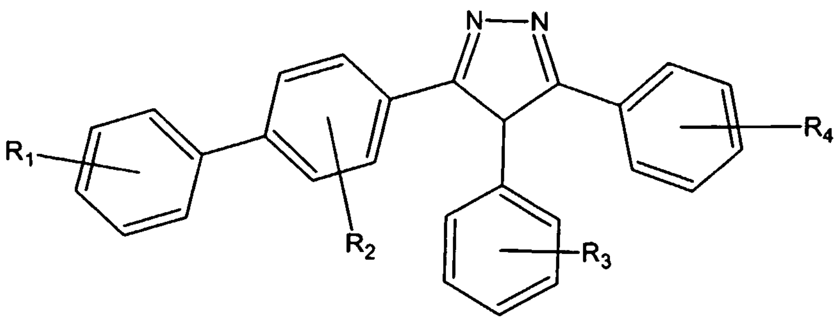

Formula VIII

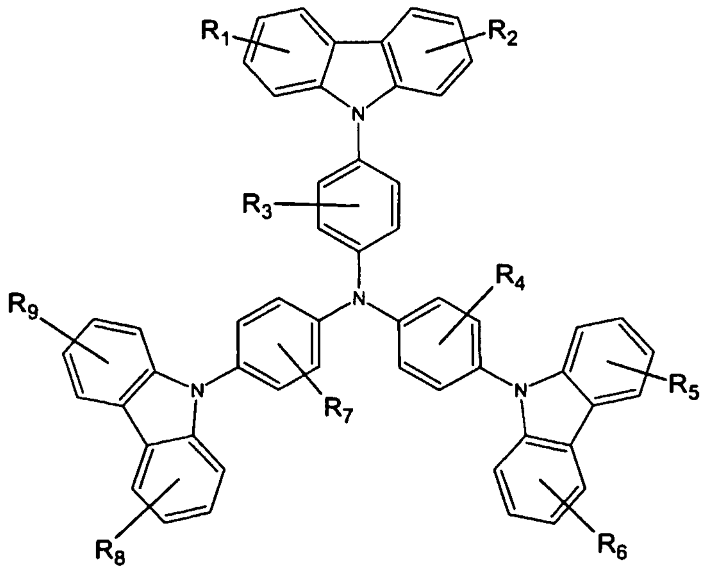

Formula IX

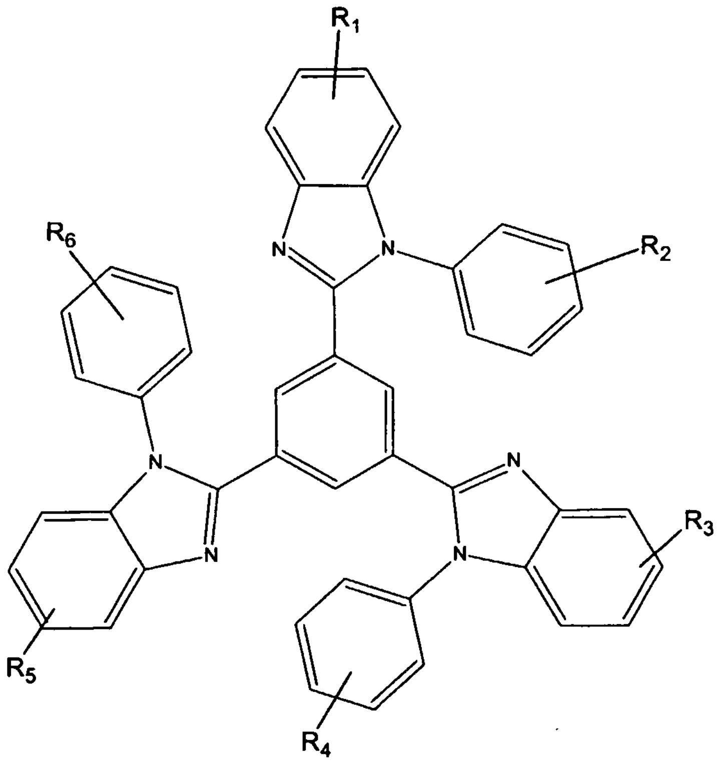

Formula X

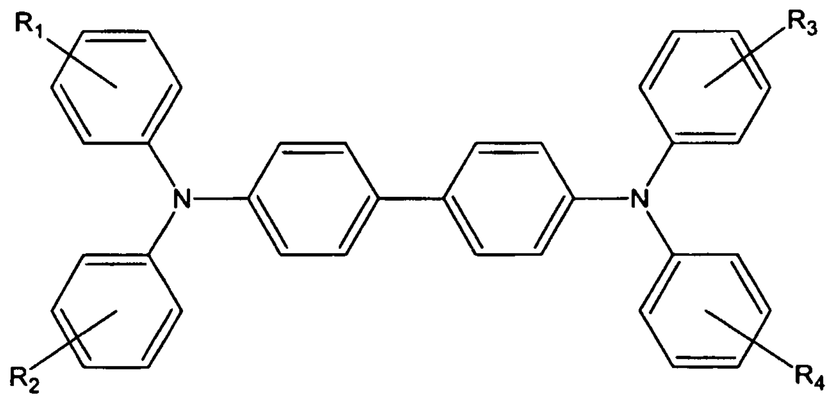

Formula XI

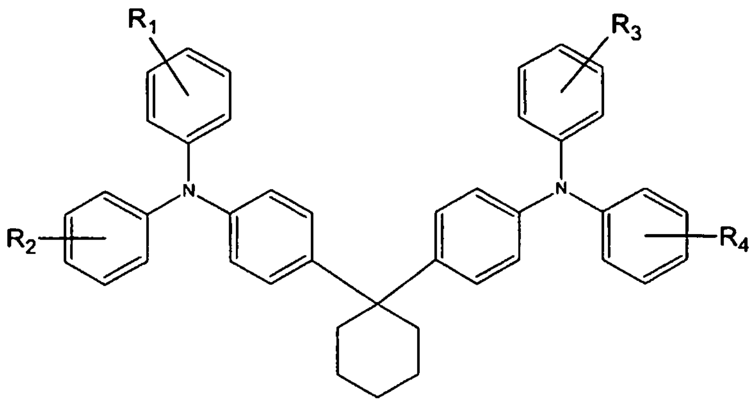

Formula XII

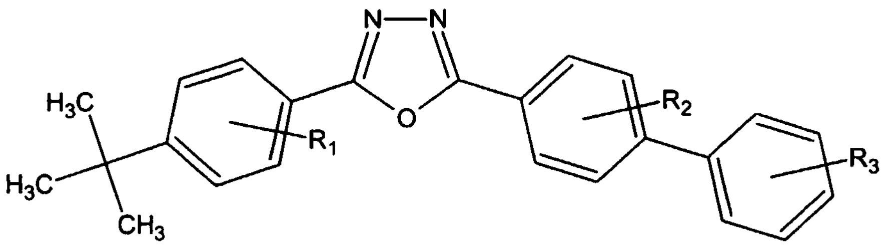

Formula XIII

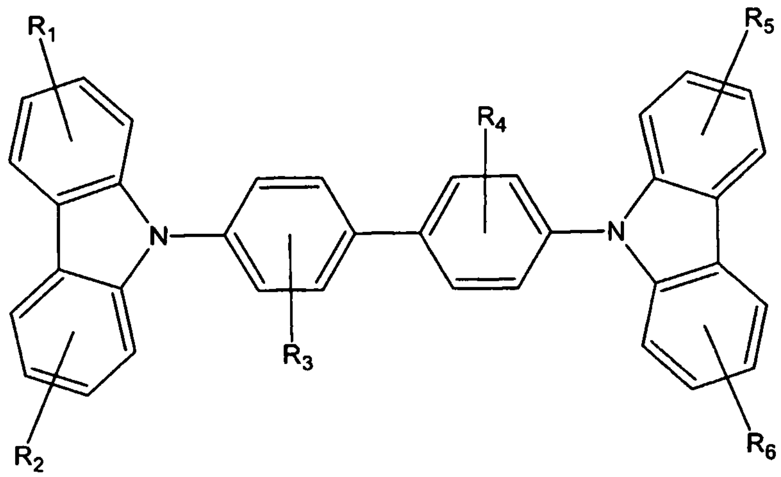

Formula XIV

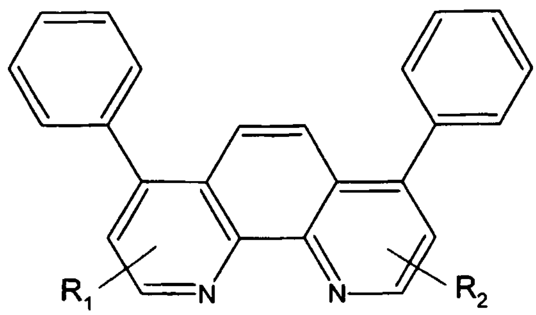

Formula XV

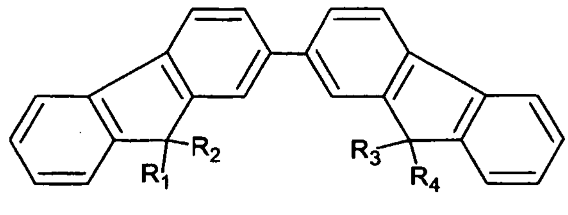

Formula XVI

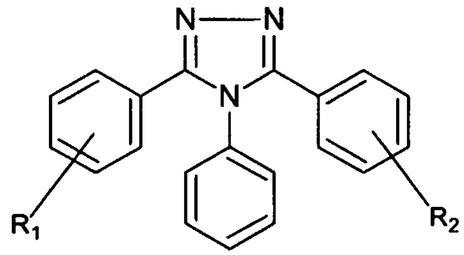

Formula XVII

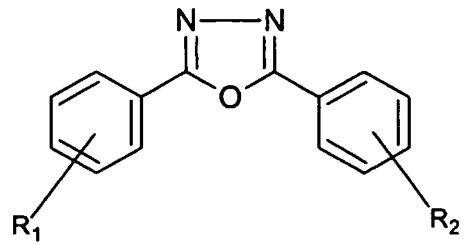

Formula XVIII

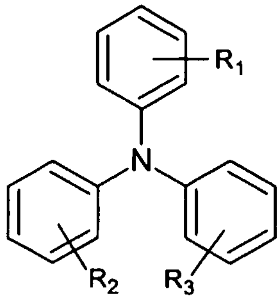

Formula XIX

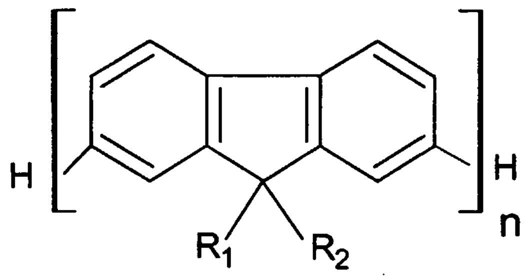

Formula XX

in which $R_1$, $R_2$, $R_3$, $R_4$, $R_5$, $R_6$, $R_7$, $R_8$ and $R_9$ are at least partially identical or different and are selected from the group comprising hydrogen, hydroxyl, alkyl, alkenyl, alkynyl, alkoxy, aryl, alkylene, arylene, amines, halogen, carboxylate derivatives, cycloalkyl, carbonyl derivatives, heterocycloalkyl, heteroaryl, heteroarylene, sulfonate, sulfate, phosphonate, phosphate, phosphine and/or phosphine oxide, wherein at least one $R_1$, $R_2$, $R_3$, $R_4$, $R_5$, $R_6$, $R_7$, $R_8$ and/or $R_9$ represents a fluorinated alkyl substituent, a fluorinated alkenyl substituent and/or a fluorinated alkynyl substituent in which at least two fluorine atoms are bonded to at least one carbon atom; and in which n = 1 to 10,000,000, preferably 10 to 1,000,000, more preferably 100 to 500,000, even more preferably 500 to 250,000, particularly preferably 1000 to 100,000 and most preferably 5000 to 50,000.

8. A conductor material as claimed in any of claims 1 to 7, wherein the conductive fluorinated organic substance is selected from the group comprising at least one compound having one of the following structural formulae XXI to XXVI:

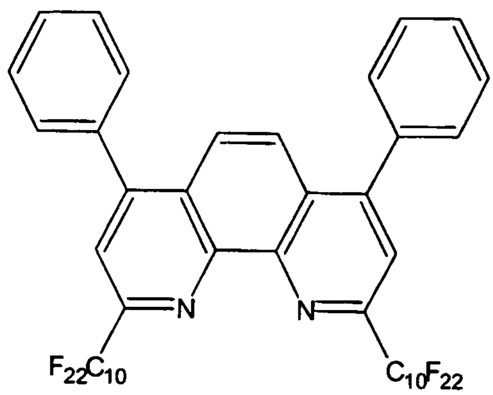

Formula XXI

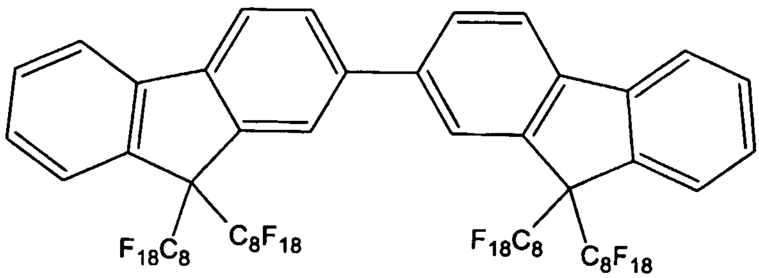

Formula XXII

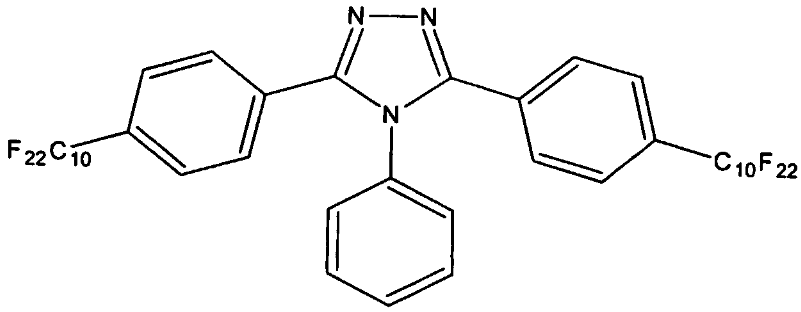

Formula XXIII

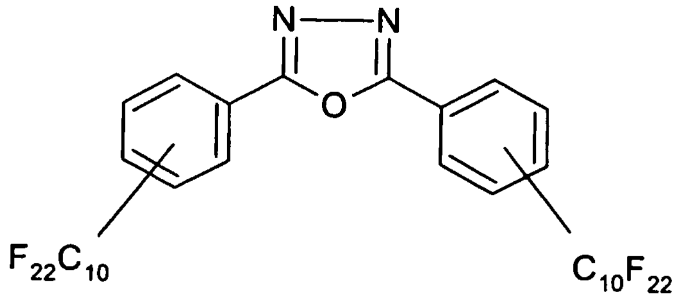

Formula XXIV

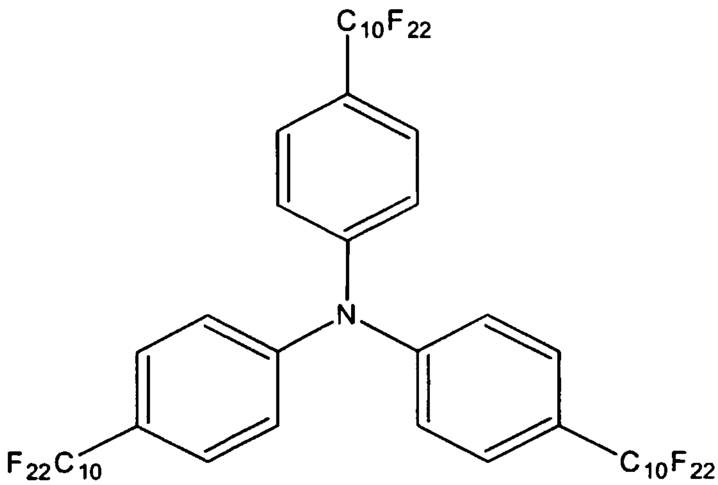

Formula XXV

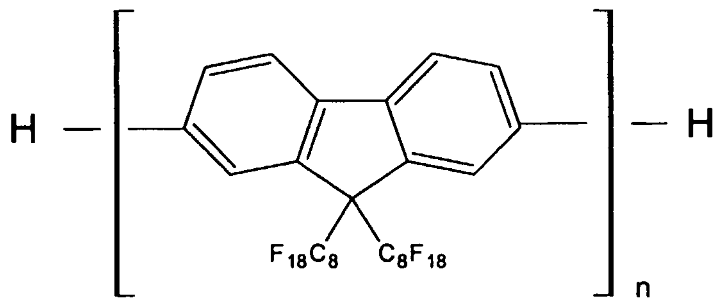

Formula XXVI

in which n = 1 to 10,000,000, preferably 10 to 1,000,000, more preferably 100 to 500,000, even more preferably 500 to 250,000, particularly preferably 1000 to 100,000 and most preferably 5000 to 50,000.

**9.** A diode, in particular an organic light-emitting diode (OLED) or polymer light-emitting diode (polyLED), comprising one or more conductor layers as claimed in any of the preceding claims 1 to 8,

**10.** A luminous means comprising at least one diode, in particular an OLED and/or polyLED as claimed in claim 9.

**Patentansprüche**

**1.** Leitermaterial für LEDs zur Verbesserung der Lichtauskopplung, wobei

- das Leitermaterial aus der Gruppe, der Lochleitermaterial, Elektronenleitermaterial und/oder Emittermaterial angehören, ausgewählt wird,
- das Leitermaterial zumindest eine leitende, fluorierte, organische Substanz mit mindestens einem fluorierten Alkyl-Substituenten, einem fluorierten Alkenyl-Substituenten und/oder einem fluorierten Alkinyl-Substituenten enthält, wobei mindestens zwei Fluoratome mit mindestens einem Kohlenstoffatom des fluorierten Substituenten eine Bindung eingegangen sind, **dadurch gekennzeichnet, dass**
- die leitende, fluorierte, organische Substanz einen Brechungsindex von ≥ 1,30 und ≤ 1,50 aufweist.

**2.** Leitermaterial nach Anspruch 1, wobei der fluorierte Substituent ein linearer oder verzweigter Alkyl-, Alkenyl- und/oder Alkinyl-Substituent ist.

**3.** Leitermaterial nach Anspruch 1 oder 2, wobei auf mindestens einen fluorierten Substituenten $C_mF_{m+x}$ angewandt wird, wobei

m = 1 bis 20, vorzugsweise m= 2 bis 16, noch besser m = 4 bis 12, und
X = 1 bis m+1, wobei m eine ganze Zahl darstellt.

**4.** Leitermaterial nach einem der Ansprüche 1 bis 3, wobei die leitende, fluorierte, organische Substanz ein Monomer, Oligomer oder Polymer ist, wobei die leitende, fluorierte Substanz vorzugsweise konjugierte Zweifach- und/oder Dreifachbindungen, vorzugsweise mit einem Molekulargewicht von ≥ 100 und ≤ 300.000, aufweist.

**5.** Leitermaterial nach einem der Ansprüche 1 bis 4, wobei die leitende, fluorierte, organische Substanz aus der Gruppe, der Arylverbindungen, perfluoriertes Adamantan, Triphenylaminverbindungen, Carbazolverbindungen, Oxadiazolverbindungen, Triazolverbindungen, Triazinverbindungen, Fluorenverbindungen, Hexaphenylbenzolverbindungen, Phenanthrolinverbindungen, Pyridinverbindungen, Polyfluoren mit perfluorierten Seitenketten, konjugierte Polymere, Poly-para-phenylen-vinylen (PPV), Polyvinylcarbazol , Metallkomplexe, insbesondere Metallkomplexe mit Al, Ga und/oder Zn als Metallion, Chinolin-Verbindungen, Acetylacetonat-Verbindungen, Bipyridin-Verbindungen, Phenathrolin-Verbindungen und/oder Metallkomplexe mit Carbonsäuren als Liganden angehören, ausgewählt wird.

6. Leitermaterial nach einem der Ansprüche 1 bis 5, wobei die leitende, fluorierte, organische Substanz einen Brechungsindex von ≤ 1,45, vorzugsweise einen Brechungsindex von ≤ 1,40, noch besser einen Brechungsindex von ≤ 1,39, am besten jedoch einen Brechungsindex von ≤ 1,37 aufweist.

7. Leitermaterial nach einem der Ansprüche 1 bis 6, wobei die leitende, fluorierte, organische Substanz aus der Gruppe, der mindestens eine Verbindung mit einer der nachfolgenden Strukturformeln I bis XX angehört, ausgewählt wird:

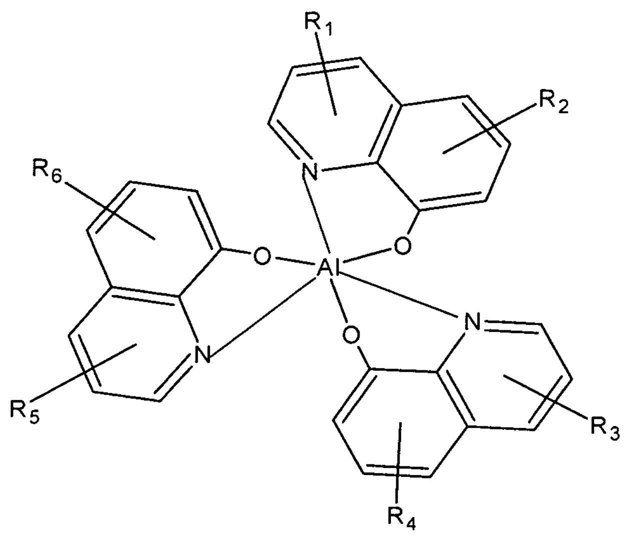

Formel I

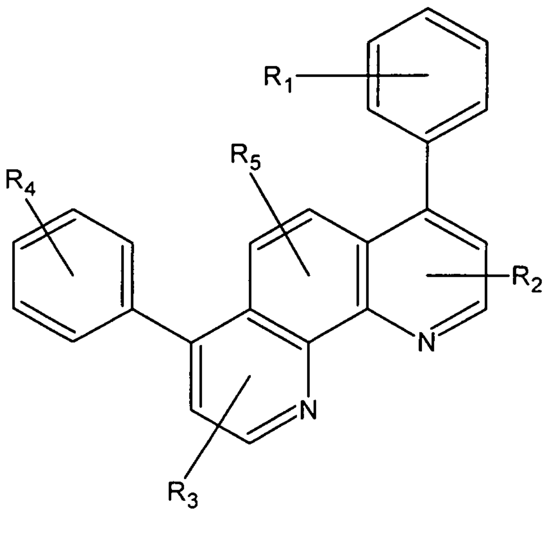

Formel II

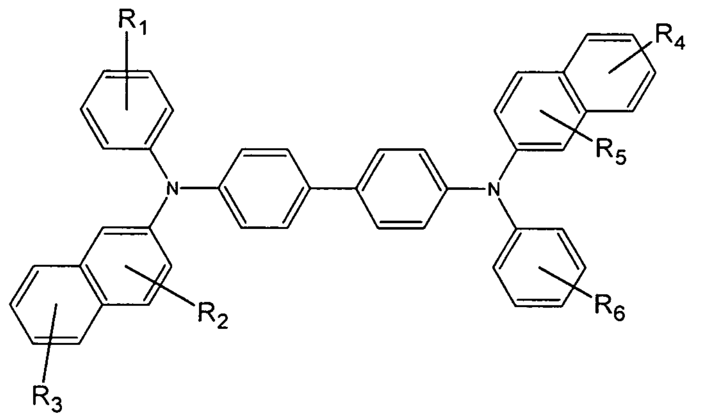

Formel III

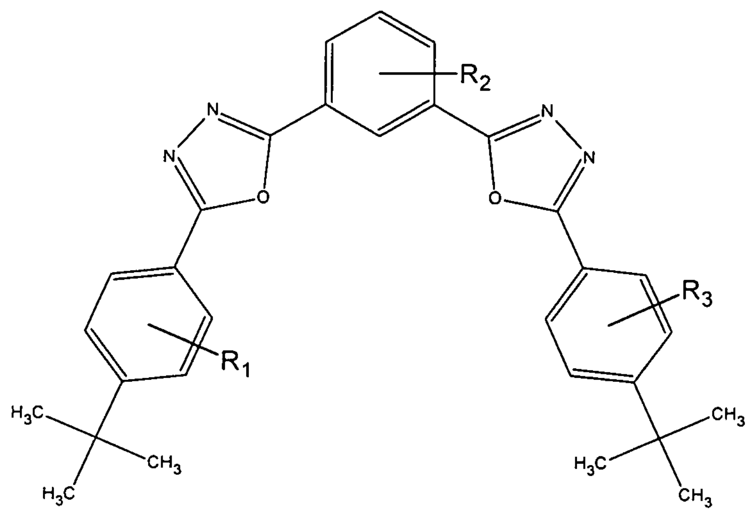

Formel IV

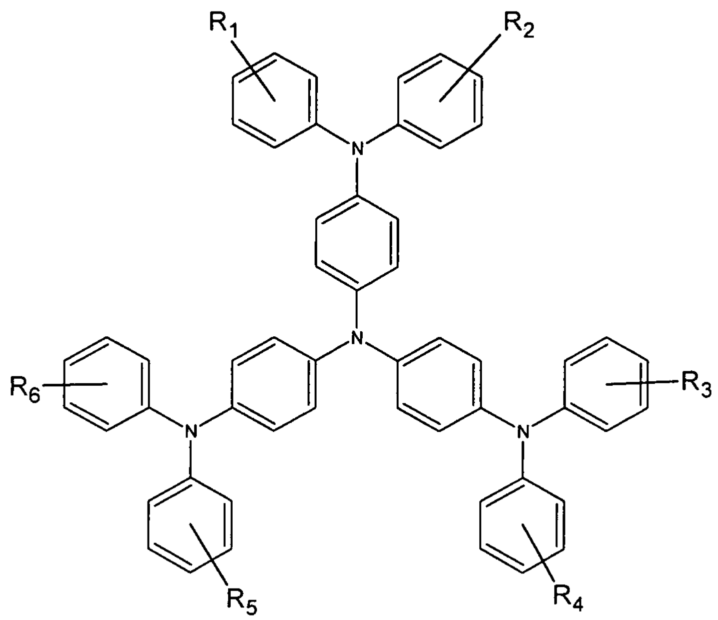

Formel V

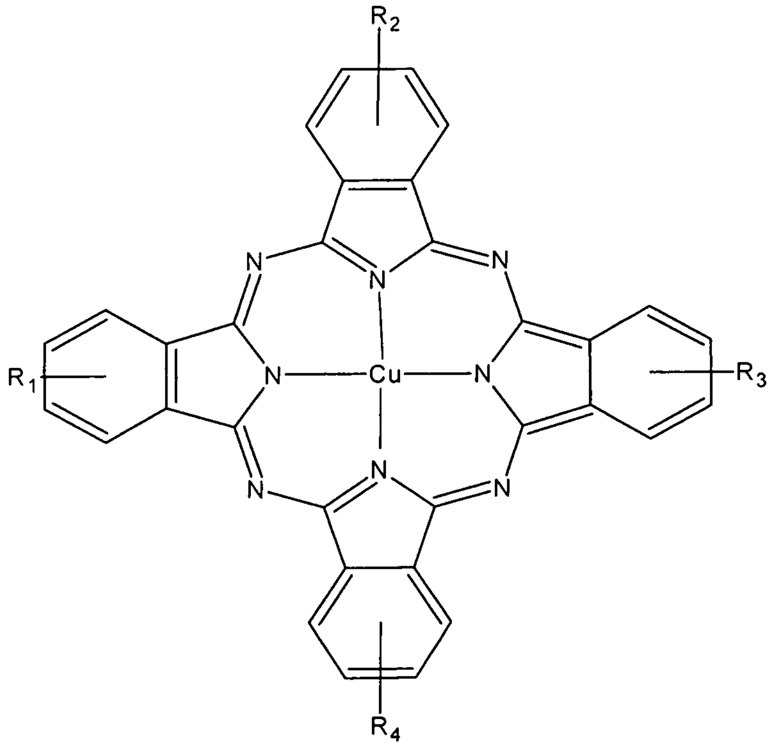

Formel VI

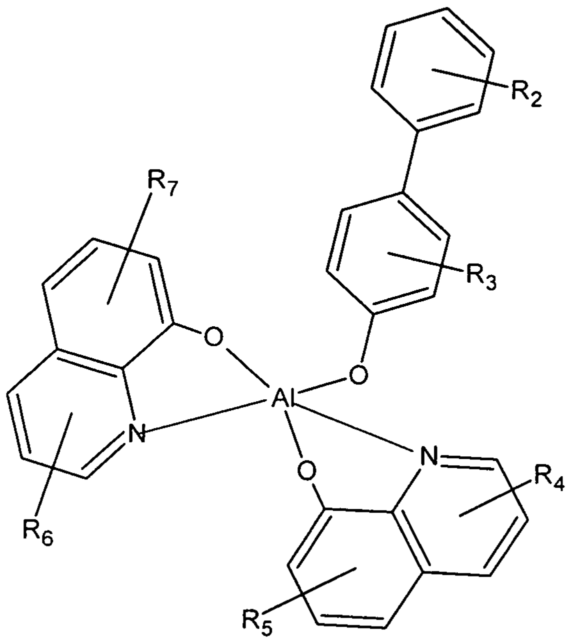

Formel VII

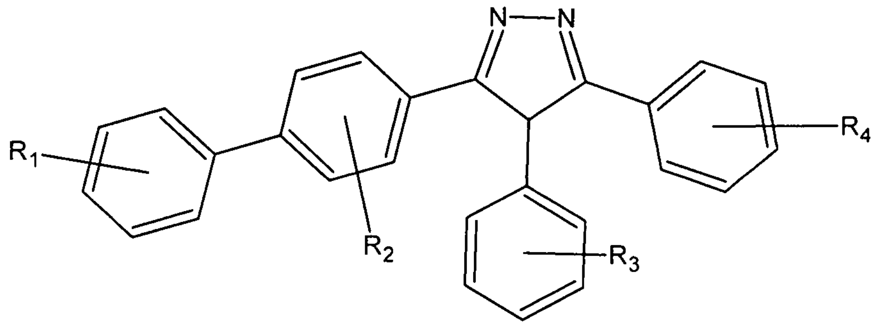

Formel VIII

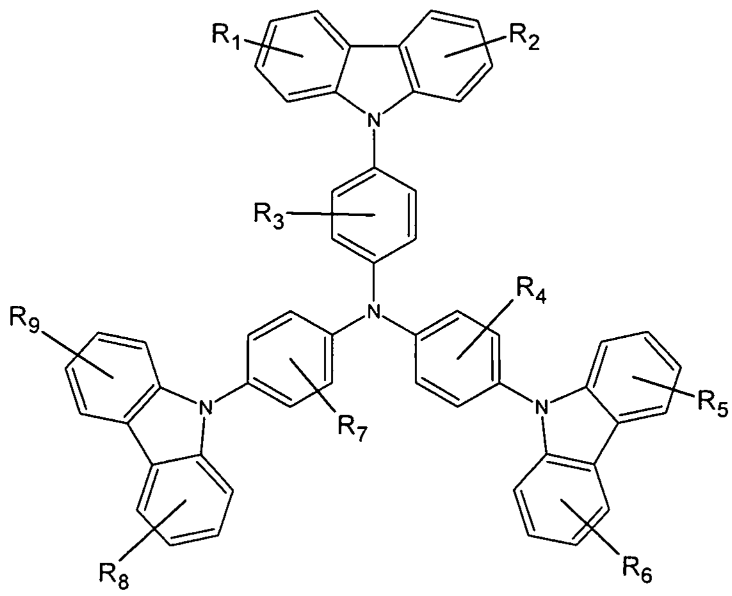

Formel IX

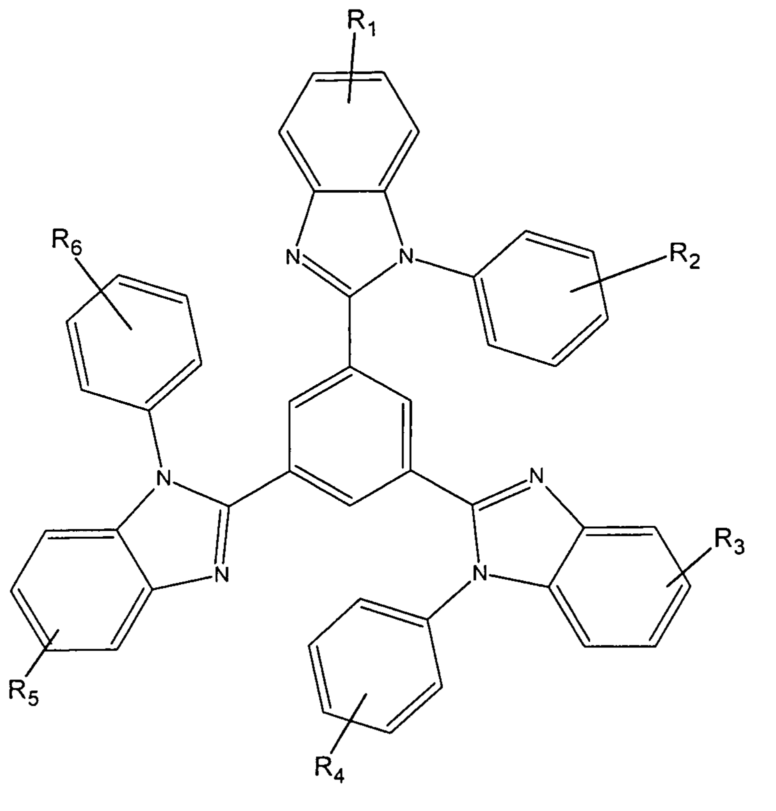

Formel X

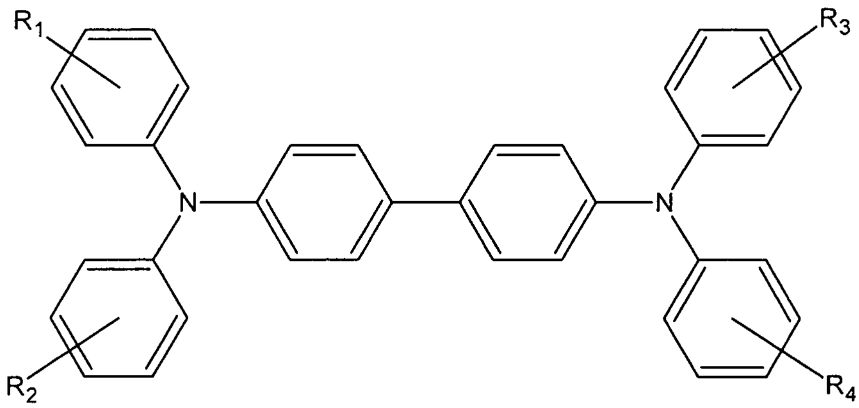

Formel XI

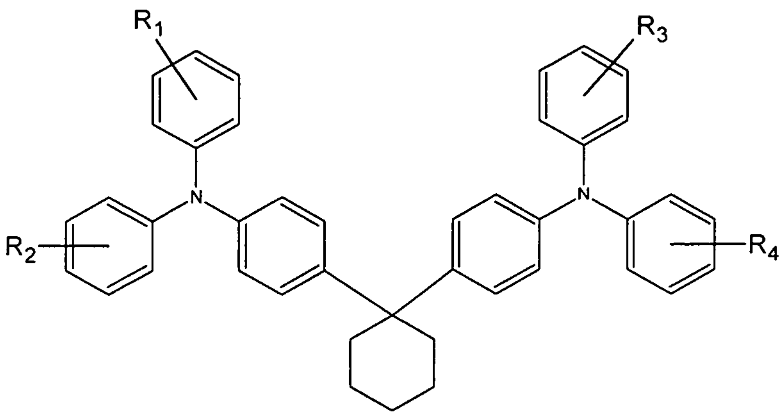

Formel XII

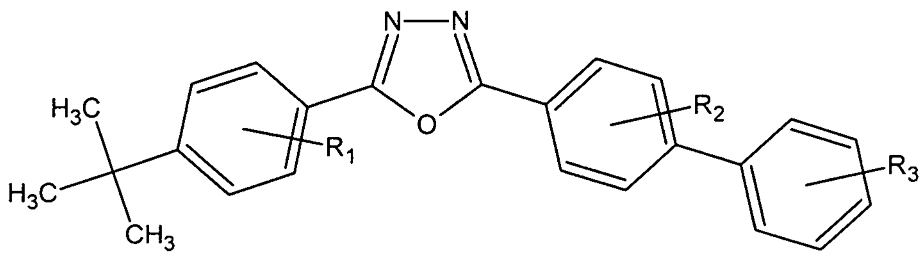

Formel XIII

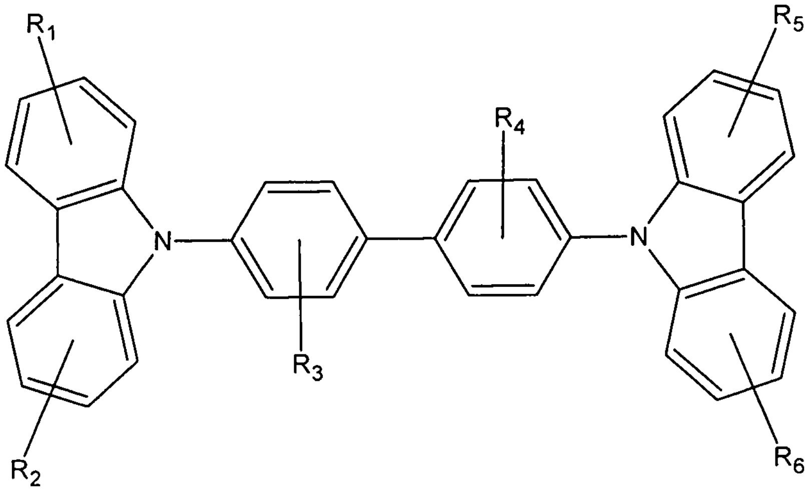

Formel XIV

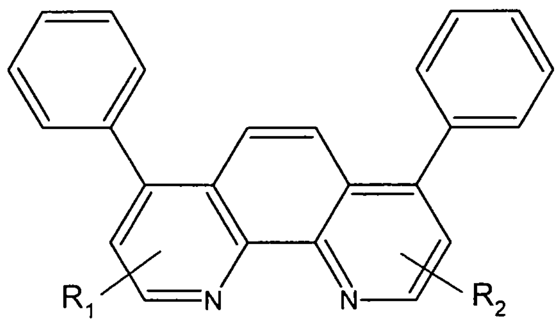

Formel XV

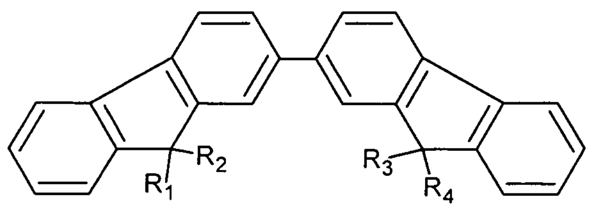

Formel XVI

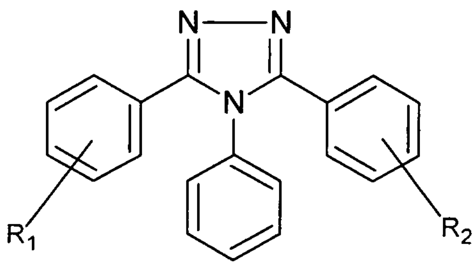

Formel XVII

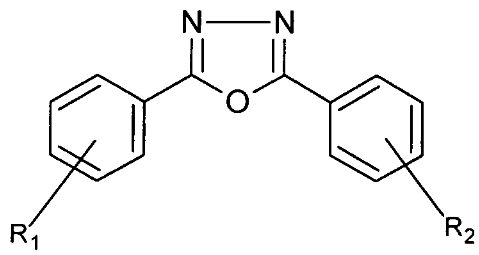

Formel XVIII

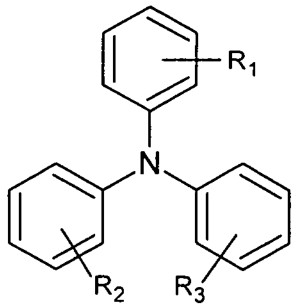

Formel XIX

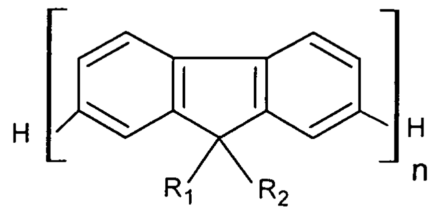

Formel XX

wobei $R_1$, $R_2$, $R_3$, $R_4$, $R_5$, $R_6$, $R_7$, $R_8$ und $R_9$ zumindest teilweise identisch oder unterschiedlich sind und aus der Gruppe, der Wasserstoff, Hydroxyl, Alkyl, Alkenyl, Alkinyl, Alkoxy, Aryl, Alkylen, Arylen, Amine, Halogen, Carboxylatderivate, Cycloalkyl, Carbonylderivate, Heterocycloalkyl, Heteroaryl, Heteroarylen, Sulphonat, Sulphat, Phosphonat, Phosphat, Phosphin und/oder Phosphinoxid angehören, ausgewählt werden, wobei zumindest ein $R_1$, $R_2$, $R_3$, $R_4$, $R_5$, $R_6$, $R_7$, $R_8$ und/oder $R_9$ einen fluorierten Alkyl-Substituenten, einen fluorierten Alkenyl-Substituenten und/oder einen fluorierten Alkinyl-Substituenten darstellt, bei dem mindestens zwei Fluoratome mit mindestens einem Kohlenstoffatom eine Bindung eingegangen sind, und
wobei n = 1 bis 10.000.000, vorzugsweise 10 bis 1.000.000, besser 100 bis 500.000, noch besser 500 bis 250.000, besonders bevorzugt 1000 bis 100.000, am besten jedoch 5.000 bis 50.000.

**8.** Leitermaterial nach einem der Ansprüche 1 bis 7, wobei die leitende, fluorierte, organische Substanz aus der Gruppe, der mindestens eine Verbindung mit der nachfolgenden Strukturformel XXI bis XXVI angehört, ausgewählt wird:

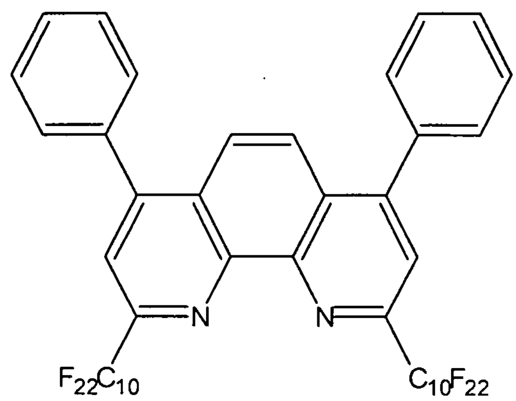

Formel XXI

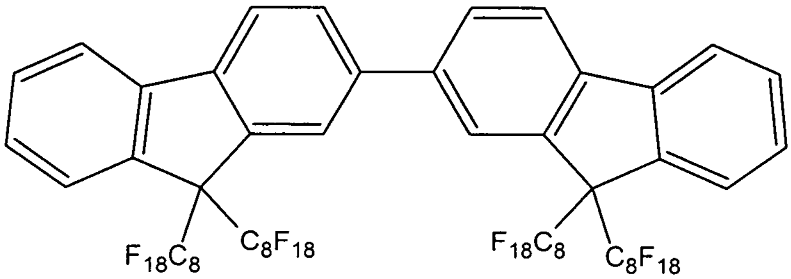

Formel XXII

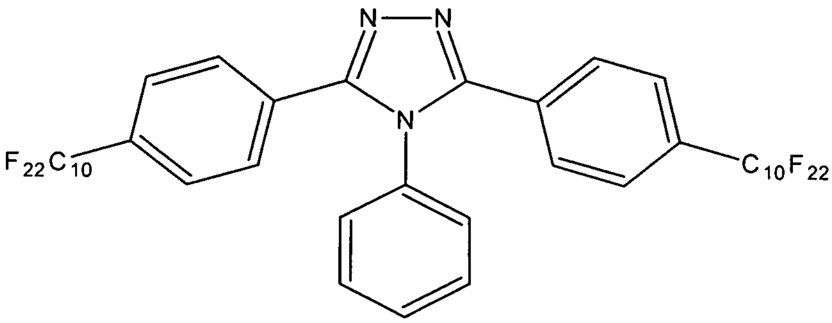

Formel XXIII

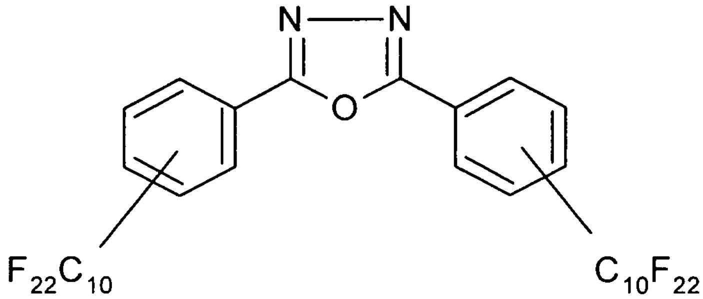

Formel XXIV

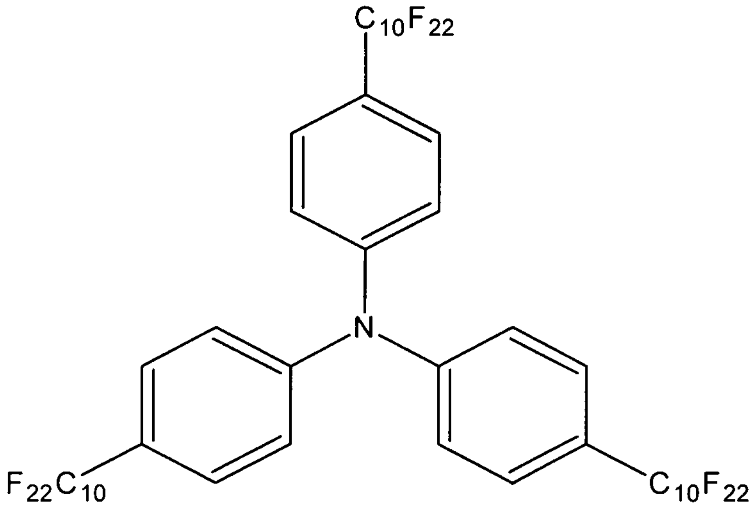

Formel XXV

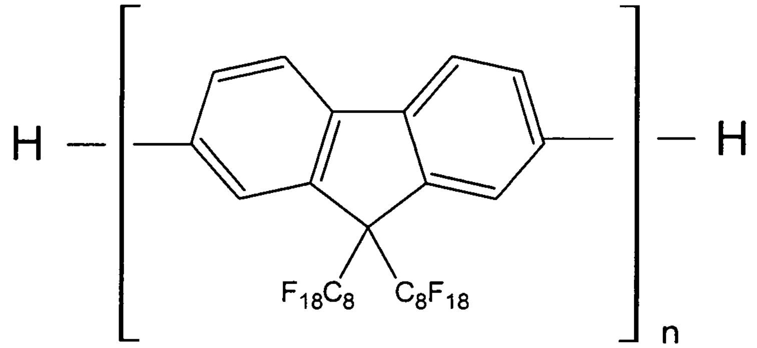

Formel XXVI

wobei n = 1 bis 10.000.000, vorzugsweise 10 bis 1.000.000, besser 100 bis 500.000, noch besser 500 bis 250.000, besonders bevorzugt 1000 bis 100.000, am besten jedoch 5000 bis 50.000.

**9.** Diode, insbesondere eine organische Leuchtdiode (OLED) oder polymere Leuchtdiode (PolyLED), mit einer oder mehreren Leiterschichten nach einem der vorangegangenen Ansprüche 1 bis 8.

**10.** Leuchtmittel mit mindestens einer Diode, insbesondere einer OLED und/oder PolyLED nach Anspruch 9.

**Revendications**

**1.** Matériau conducteur destiné aux diodes DEL pour améliorer le découplage de la lumière, dans lequel :

- le matériau conducteur est choisi dans le groupe comprenant un matériau conducteur de trous, un matériau

conducteur d'électrons et/ou un matériau émetteur d'électrons,
- le matériau conducteur comprend au moins une substance organique fluorée conductrice ayant au moins un substituant alkyle fluoré, un substituant alcényle fluoré et/ou un substituant alcynyle fluoré, dans lequel au moins deux atomes de fluor sont liés à au moins un atome de carbone du substituant fluoré, **caractérisé en ce que**
- la substance organique fluorée conductrice a un indice de réfraction ≥ 1,30 et ≤ 1,50.

**2.** Matériau conducteur selon la revendication 1, dans lequel le substituant fluoré est un substituant alkyle, alcényle et/ou alcynyle linéaire ou ramifié.

**3.** Matériau conducteur selon la revendication 1 ou 2, dans lequel la formule $C_mF_{m+x}$ s'applique par rapport à au moins un substituant fluoré, dans lequel :

m = 1 à 20, de préférence m = 2 à 16, et mieux encore m = 4 à 12 ; et
X = 1 à m+1, m étant un nombre entier.

**4.** Matériau conducteur selon l'une quelconque des revendications 1 à 3, dans lequel la substance organique fluorée conductrice est un monomère, un oligomère ou un polymère, la substance fluorée conductrice comprenant de préférence des liaisons conjuguées doubles et/ou triples et ayant de préférence un poids moléculaire entre ≥ 100 et ≤ 300 000.

**5.** Matériau conducteur selon l'une quelconque des revendications 1 à 4, dans lequel la substance organique fluorée conductrice est choisie dans le groupe comprenant des composés d'aryle, de l'adamantane perfluoré, des composés de triphénylamine, des composés de carbazole, des composés d'oxadiazole, des composés de triazole, des composés de triazine, des composés de fluorène, des composés d'hexaphénylbenzène, des composés de phénanthroline, des composés de pyridine, du polyfluorène avec des chaînes latérales perfluorées, des polymères conjugués, le poly-para-phénylènevinylène (PPV), le poly(carbazole de vinyle), des complexes métalliques, en particulier des complexes métalliques comprenant Al, Ga et/ou Zn comme ion de métal, des composés de quinoléine, des composés d'acétylacétonate, des composés de bipyridine, des composés de phénathroline et/ou des complexes métalliques comprenant des acides carboxyliques comme ligand.

**6.** Matériau conducteur selon l'une quelconque des revendications 1 à 5, dans lequel la substance organique fluorée conductrice a un indice de réfraction ≤ 1,45, de préférence un indice de réfraction ≤ 1,40, mieux encore un indice de réfraction ≤ 1,39, bien mieux encore un indice de réfraction ≤ 1,37.

**7.** Matériau conducteur selon l'une quelconque des revendications 1 à 6, dans lequel la substance organique fluorée conductrice est choisie dans le groupe comprenant au moins un composé ayant l'une des formules structurelles suivantes I à XX :

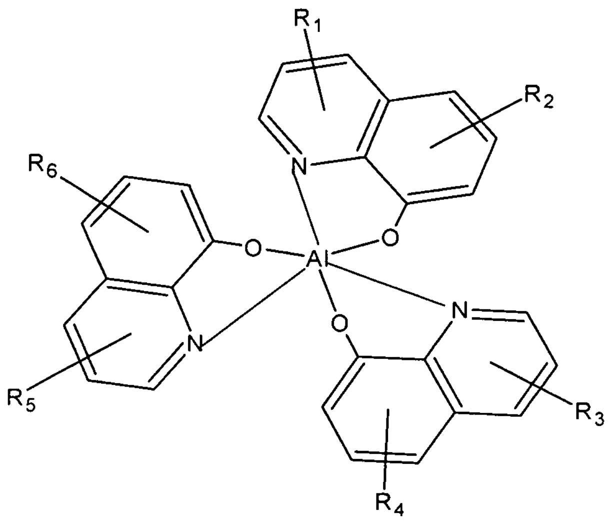

Formule I

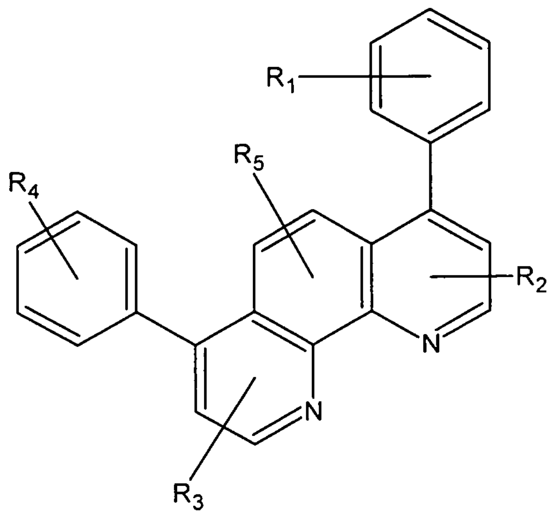

Formule II

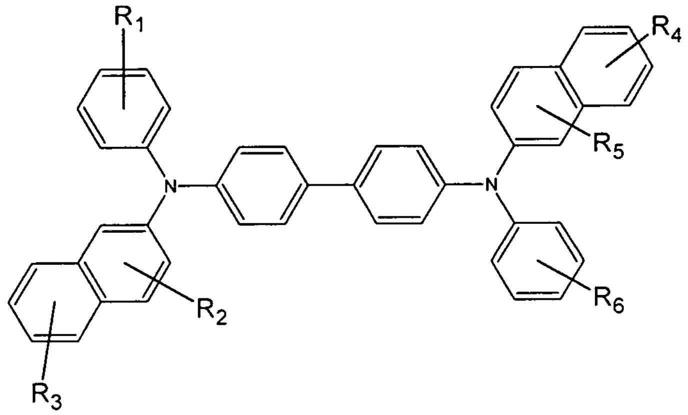

Formule III

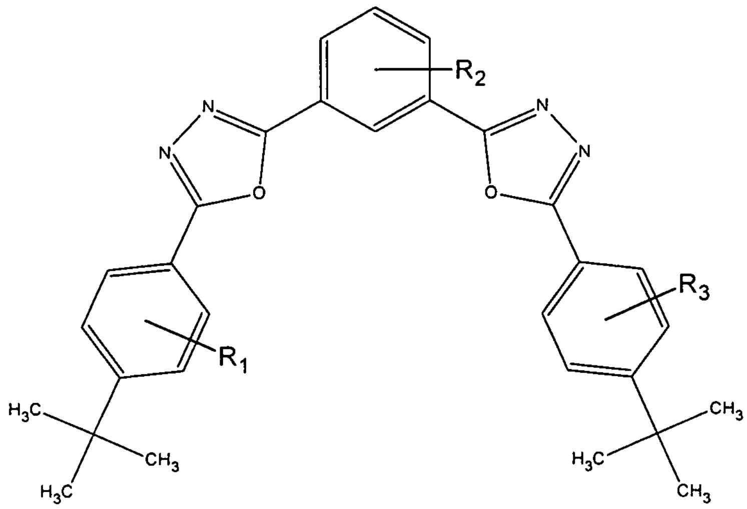

Formule IV

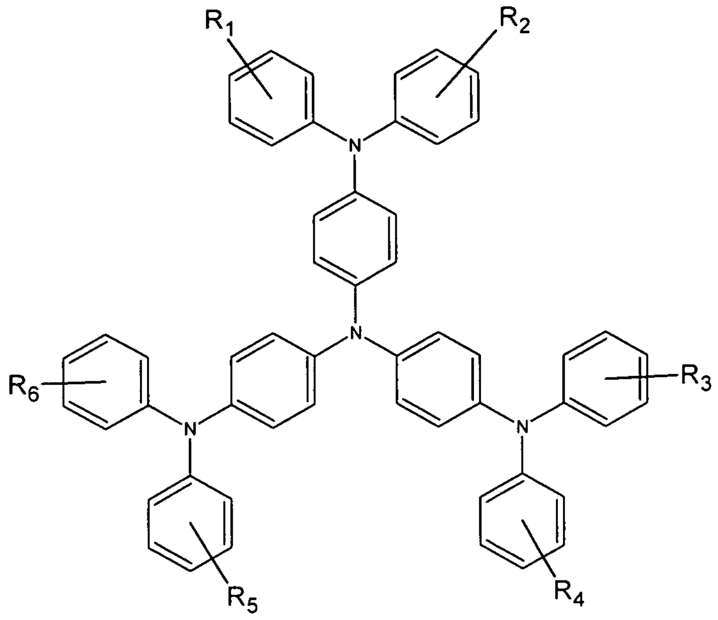

Formule V

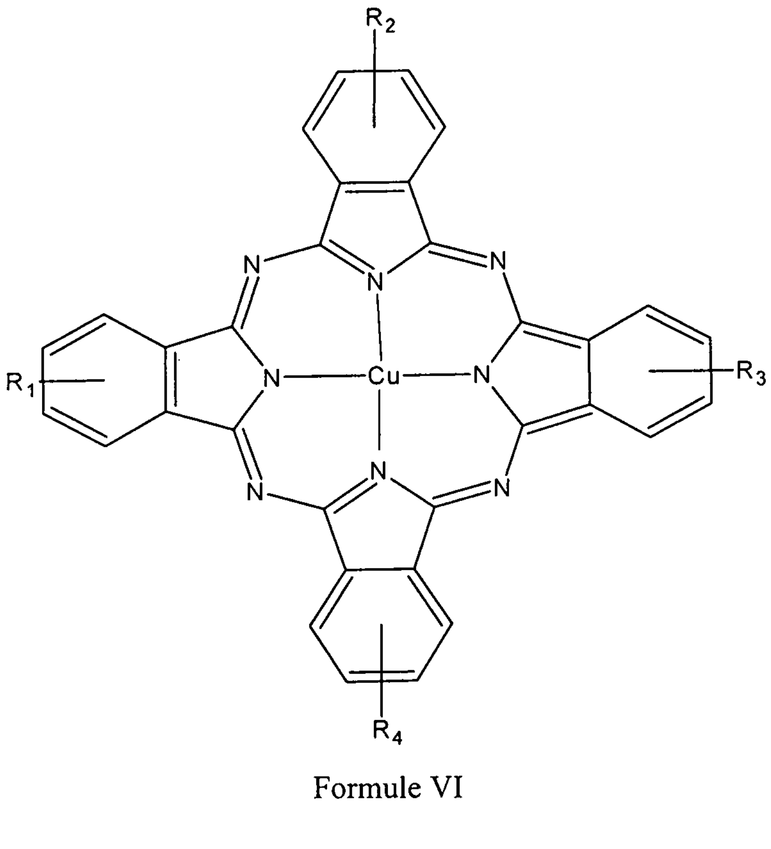

Formule VI

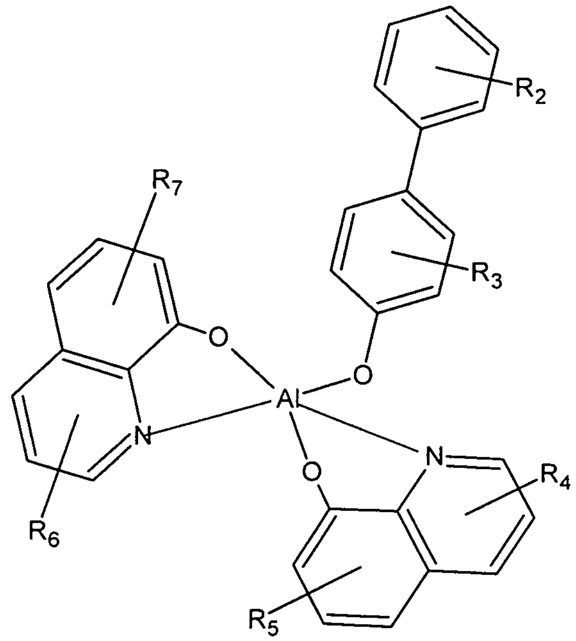

Formule VII

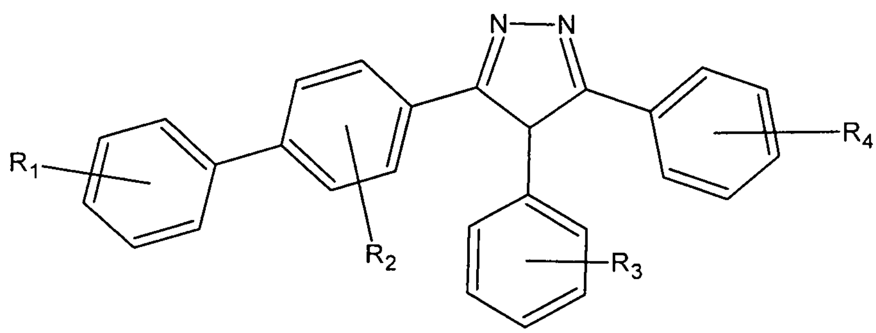

Formule VIII

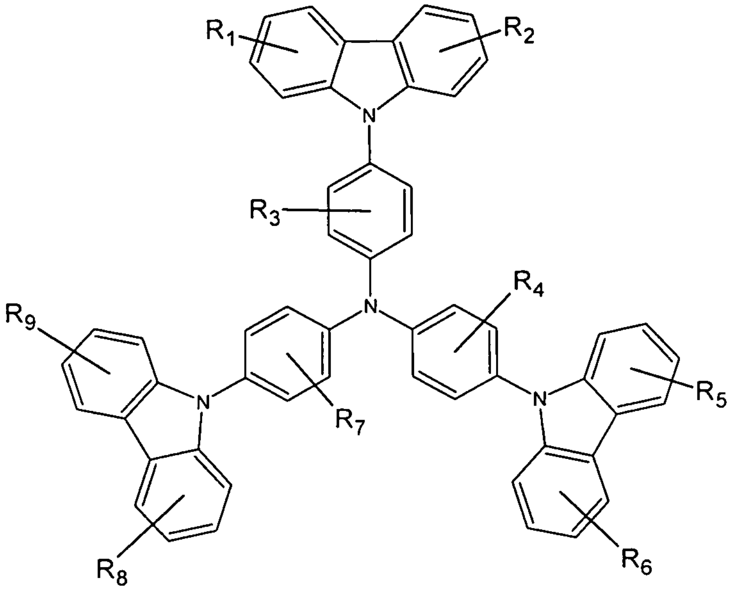

Formule IX

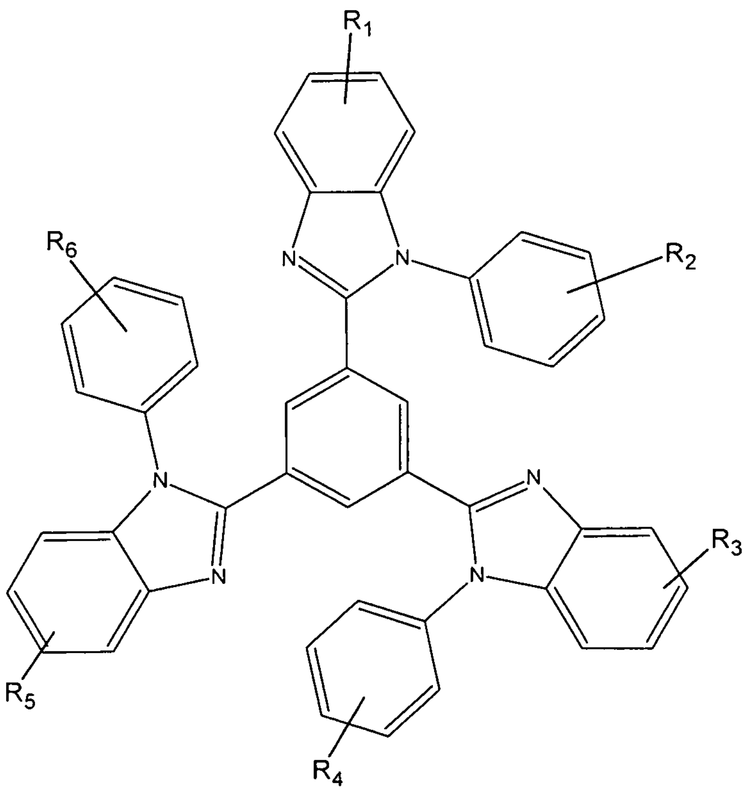

Formule X

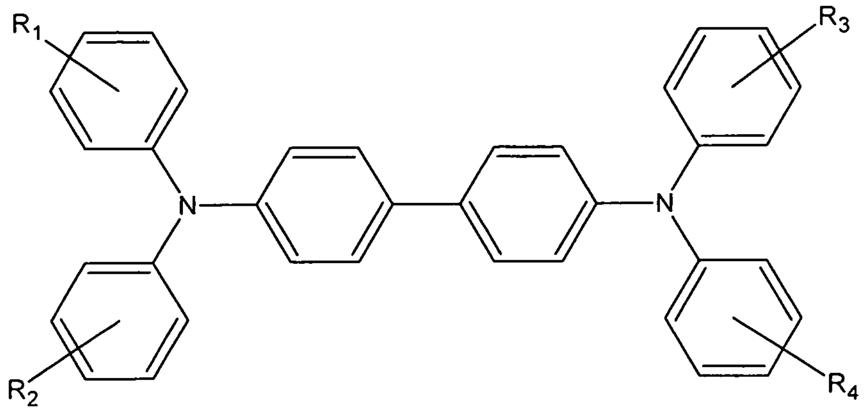

Formule XI

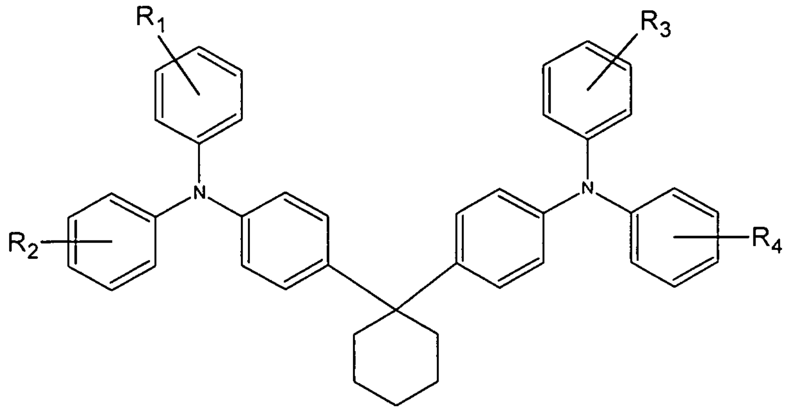

Formule XII

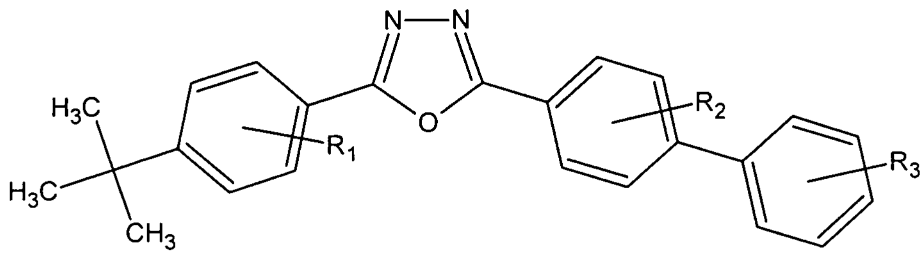

Formule XIII

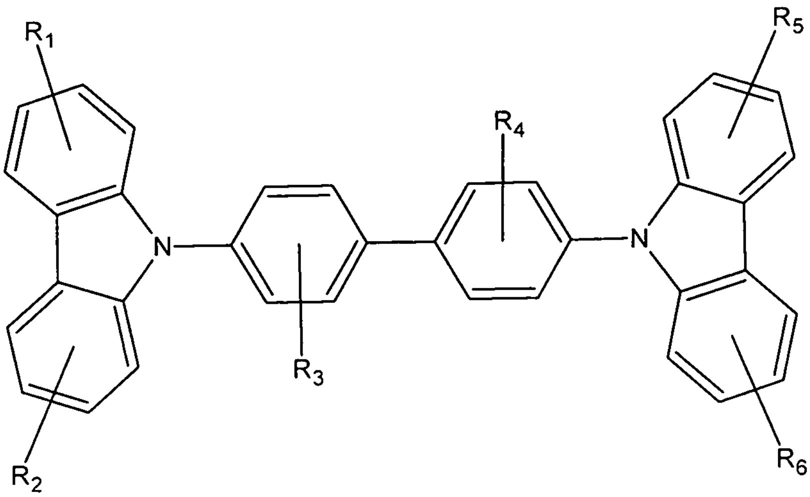

Formule XIV

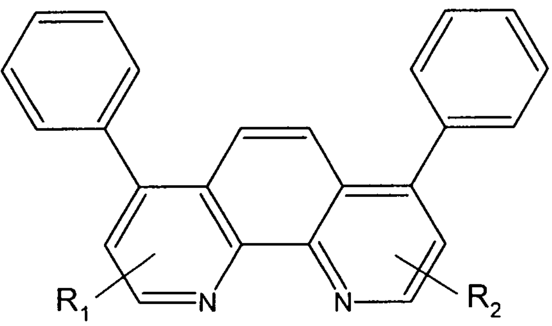

Formule XV

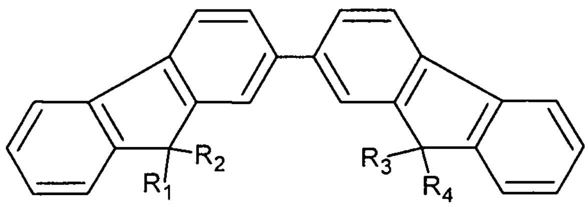

Formule XVI

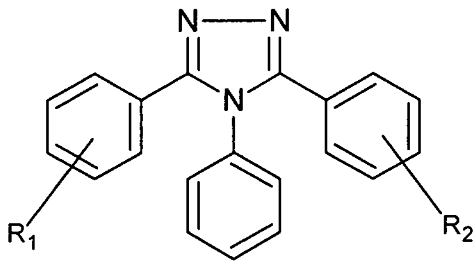

Formule XVII

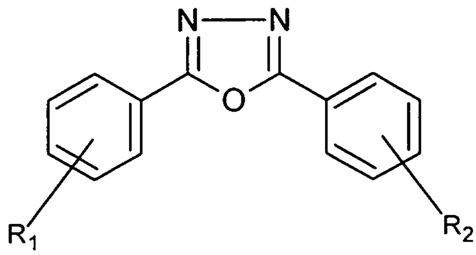

Formule XVIII

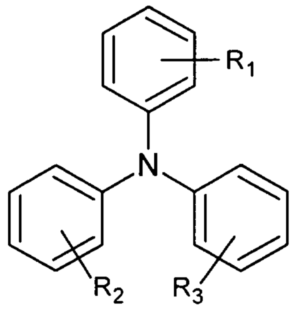

Formule XIX

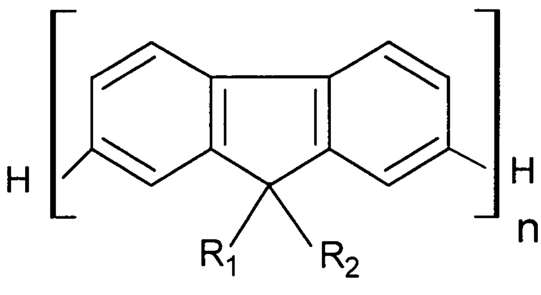

Formule XX

dans lesquelles $R_1$, $R_2$, $R_3$, $R_4$, $R_5$, $R_6$, $R_7$, $R_8$ $R_9$ sont au moins en partie identiques ou différents et sont choisis dans le groupe comprenant les radicaux suivants : hydrogène, hydroxyle, alkyle, alcényle, alcynyle, alcoxy, aryle, alkylène, arylène, amines, halogène, dérivés de carboxylate, cycloalkyle, dérivés de carbonyle, hétérocycloalkyle, hétéroaryle, hétéroarylène, sulfonate, sulfate, phosphonate, phosphate, phosphine et/ou oxyde de phosphine, dans lesquels au moins un radical parmi $R_1$, $R_2$, $R_3$, $R_4$, $R_5$, $R_6$, $R_7$, $R_8$ et $R_9$ représente un substituant alkyle fluoré, un substituant alcényle fluoré, un substituant alcynyle fluoré, dans lesquels au moins deux atomes de fluor sont liés à au moins un atome de carbone ; et
dans lequel n = 1 à 10 000 000, de préférence 10 à 1 000 000, mieux encore de 100 à 500 000, bien mieux encore 500 à 250 000, nettement mieux 1000 à 100 000 et tout particulièrement 5000 à 50 000.

**8.** Matériau conducteur selon l'une quelconque des revendications 1 à 7, dans lequel la substance organique fluorée conductrice est choisie dans le groupe comprenant au moins un composé ayant l'une des formules structurelles suivantes XXI à XXVI :

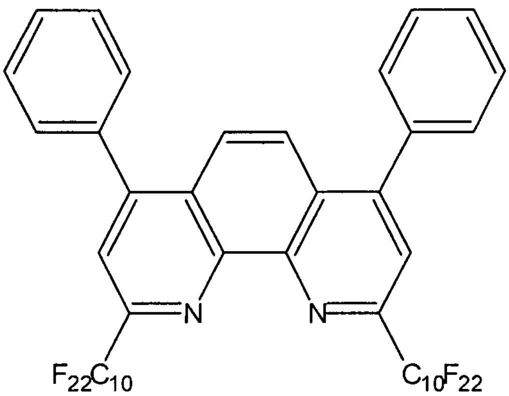

Formule XXI

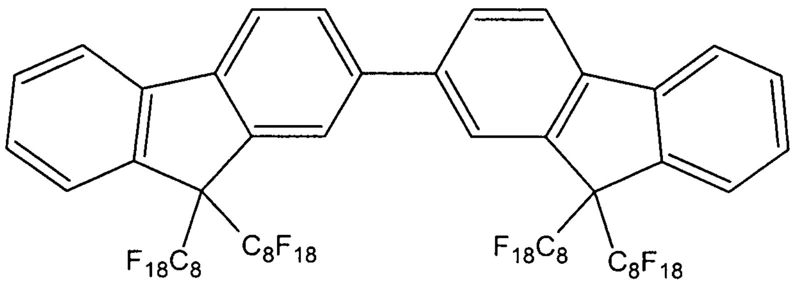

Formule XXII

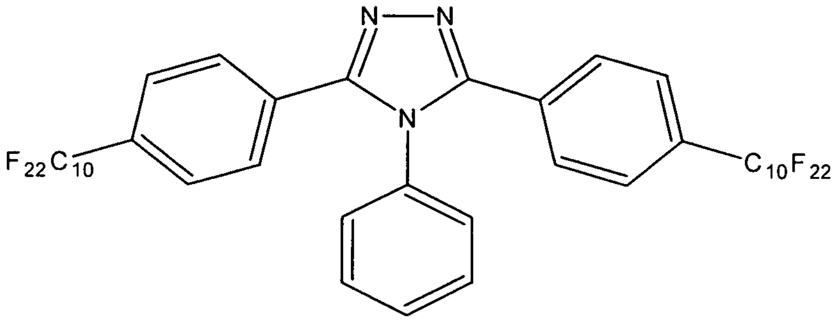

Formule XXIII

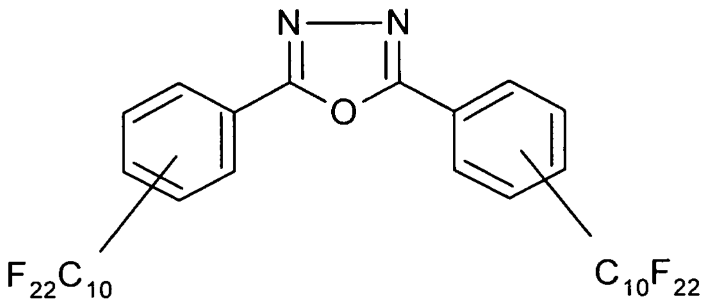

Formule XXIV

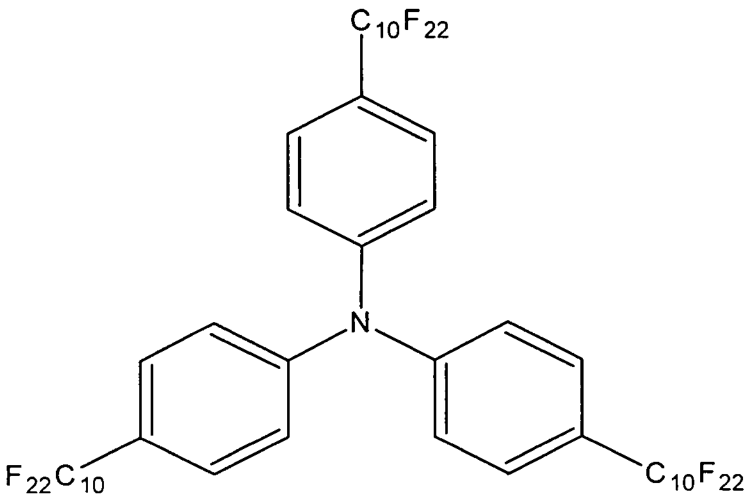

Formule XXV

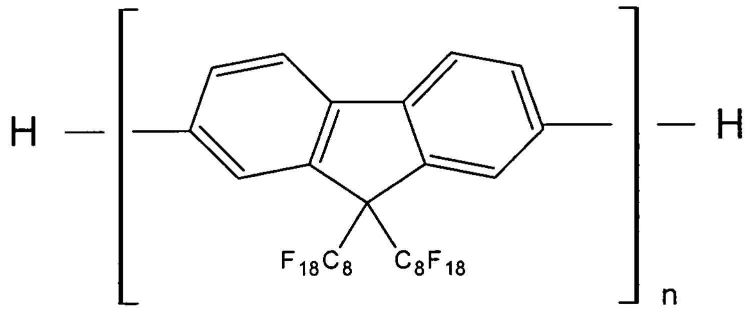

Formule XXVI

dans lesquelles n = 1 à 10 000 000, de préférence 10 à 1 000 000, mieux encore 100 à 500 000, bien mieux encore 500 à 250 000, nettement mieux encore 1000 à 100 000 et tout particulièrement 5000 à 50 000.

**9.** Diode, en particulier diode électroluminescente organique (DELO) ou diode électroluminescente polymère (polyDEL), comprenant une ou plusieurs couches conductrices selon l'une quelconque des revendications précédentes 1 à 8.

**10.** Moyen lumineux comprenant au moins une diode, en particulier une diode DELO et/ou une diode polyDEL selon la revendication 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0848579 A2